# EUROPEAN PATENT APPLICATION

(11) **EP 4 748 526 A2**
(43) Date of publication of application: **27.05.2026**
(21) Application number: 25218138.3
(22) Date of filing: 24.11.2025
(51) Int. Cl.: B23K 1/008

(54) **REFLOW SOLDERING OVEN**

(30) Priority: 26.11.2024 GB 202417351
(71) Applicant: Illinois Tool Works Inc., Glenview IL 60025 (US)
(72) Inventor: DIEPSTRATEN, Gerardus Johannes Adrianus Maria, Glenview, 60025 (US)
(74) Representative: HGF

(57) **Abstract**

Aspects of the present invention relate to a reflow soldering oven comprising a vacuum chamber. A first conveyor is positioned outside of the vacuum chamber and a second conveyor is positioned inside the vacuum chamber. The first conveyor has a first conveyor side rail. The second conveyor has a second conveyor side rail. Each of the first conveyor side rail and the second conveyor side rail has a longitudinal axis. The reflow soldering oven comprises a conveyor alignment mechanism having an alignment member. The alignment member is movably coupled to one of the first conveyor side rail and the second conveyor side rail. The conveyor alignment mechanism is configured to move the alignment member between: a first position in which the alignment member is spaced apart from the other of the first conveyor side rail and the second conveyor side rail, and a second position in which the alignment member engages the other of the first conveyor side rail and the second conveyor side rail such that the first conveyor and the second conveyor are held in an aligned configuration in which the longitudinal axis of the first conveyor side rail is aligned with the longitudinal axis of the second conveyor side rail.

## Description

### BACKGROUND

The present invention relates to a reflow soldering oven, for example a reflow soldering oven for soldering an electronic circuit board. More particularly, the present invention relates to a reflow soldering oven including a vacuum chamber, for example a reflow soldering vacuum chamber.

During manufacture of printed circuit boards, Electronic elements are mounted on the circuit boards generally by means of a process known as "reflow soldering". In a typical reflow soldering process, solder paste (e.g. tin paste) is deposited onto selected areas of a circuit board, and a wire of one or more electronic elements is inserted into the deposited solder paste. The circuit board then passes through a reflow soldering oven in which the soldering paste refluxes (i.e. is heated to a melting or reflux temperature) in a heating area and then cools in a cooling area to form solder joints electrically and mechanically connecting the wires of the electronic components to the circuit board. As used herein, the term "circuit board" comprises a substrate assembly of any type of electronic element, such as a wafer substrate.

During the reflow soldering process, air or gas filled spaces, called voids, can be formed in the solder, for example in the bulk of the solder or at the intermetallic boundaries of the solder joint. Such voids may be caused by trapped flux gases or inadequate wetting of the solder. Larger voids may lead to mechanical weakness, electrical resistance, poor heat dissipation and reliability issues. In high-power electronics, such issues may ultimately result in component failure.

Reflow soldering ovens with integrated vacuum chambers, which may be referred to as reflow soldering vacuum chambers, significantly reduce voids in solder joints by using a vacuum process during the reflow phase. The integration of a vacuum chamber in a reflow soldering oven is an efficient method to reduce voiding. Typically, the vacuum chamber is built in one or two zones in the part of the reflow soldering oven where the solder is liquidus (i.e. the zones of the reflow soldering oven with the highest temperatures). The reduced pressure in the vacuum chamber facilitates the removal of volatile gases in the solder.

Circuit boards are transferred through the components of the reflow soldering oven, including heating areas, cooling areas and vacuum chambers using conveyors. The vacuum chamber needs to be completely sealed to generate a low pressure and so the conveyors need to be split. As such, a first conveyor may be provided from the entrance of the reflow soldering oven to the vacuum chamber, a second conveyor may be positioned within the vacuum chamber and a third conveyor may be provided from the exit of the vacuum chamber to the exit of the reflow soldering oven, typically in the cooling area of the reflow soldering oven.

The speed of the conveyors is relatively high in order to maximise the efficiency of the reflow soldering process and to ensure that the time the solder is above its liquidus temperature does not exceed the requirements of the solder material (typically less than 90 seconds). Due to the different temperatures in different components of the reflow soldering oven and the different properties (e.g. extension and/or thermal coefficients) of the materials used to manufacture the different components of the reflow soldering oven, ensuring that the conveyors are correctly aligned (and retained in the aligned position) is challenging.

Misalignment of the conveyors can result in the circuit boards getting stuck or jammed between conveyors. Vibration of the circuit boards may also cause components to fall off or be displaced on the circuit boards. This can result in machine downtime and the need to scrap affected circuit boards.

It is known to provide the conveyors with width adjustment mechanisms in order to accommodate circuit boards of different sizes. The width adjustment mechanisms may be manual or automatic. Whilst width adjustment mechanisms may be used to improve the alignment of adjacent conveyors, by accommodating discrepancies in the relative positions of the adjacent conveyors, the alignment achieved is not precise enough to prevent circuit boards becoming jammed between the adjacent conveyors.

### BRIEF SUMMARY

Aspects and embodiments of the invention provide a reflow soldering oven as claimed in the appended claims.

According to an aspect of the invention there is provided a reflow soldering oven comprising: a vacuum chamber; a first conveyor that is positioned outside of the vacuum chamber; and a second conveyor that is positioned inside the vacuum chamber; wherein the first conveyor comprises a first conveyor side rail having a longitudinal axis, and the second conveyor comprises a second conveyor side rail having a longitudinal axis; and wherein the reflow soldering oven comprises: a conveyor alignment mechanism comprising an alignment member; wherein the alignment member is movably coupled to one of the first conveyor side rail and the second conveyor side rail.

The invention thus improves the transfer of items, for example circuit boards, between adjacent conveyors in a reflow soldering oven, in particular reflow soldering ovens that include a vacuum chamber. Advantageously, this improves the efficiency of reflow soldering processes and reduces wastage of components and minimises machine downtime.

The conveyor alignment mechanism may be configured to move the alignment member between: a first position in which the alignment member is spaced apart from the other of the first conveyor side rail and the second conveyor side rail, and a second position in which the alignment member engages the other of the first conveyor side rail and the second conveyor side rail such that the first conveyor and the second conveyor are held in an aligned configuration in which the longitudinal axis of the first conveyor side rail is aligned with the longitudinal axis of the second conveyor side rail.

According to an aspect of the invention there is provided a reflow soldering oven comprising: a vacuum chamber; a first conveyor that is positioned outside of the vacuum chamber; and a second conveyor that is positioned inside the vacuum chamber; wherein the first conveyor comprises a first conveyor side rail having a longitudinal axis, and the second conveyor comprises a second conveyor side rail having a longitudinal axis; and wherein the reflow soldering oven comprises: a conveyor alignment mechanism comprising an alignment member; wherein the alignment member is movably coupled to one of the first conveyor side rail and the second conveyor side rail, and the conveyor alignment mechanism is configured to move the alignment member between: a first position in which the alignment member is spaced apart from the other of the first conveyor side rail and the second conveyor side rail, and a second position in which the alignment member engages the other of the first conveyor side rail and the second conveyor side rail such that the first conveyor and the second conveyor are held in an aligned configuration in which the longitudinal axis of the first conveyor side rail is aligned with the longitudinal axis of the second conveyor side rail.

The invention thus improves the transfer of items, for example circuit boards, between adjacent conveyors in a reflow soldering oven, in particular reflow soldering ovens that include a vacuum chamber. Advantageously, this improves the efficiency of reflow soldering processes and reduces wastage of components and minimises machine downtime.

In examples of the invention, the other of the first conveyor and the second conveyor may include an opening within which the alignment member is at least partially received when the first conveyor and the second conveyor are in the aligned configuration.

The opening may be provided in the side rail of the other of the first conveyor and the second conveyor.

The opening may form part of a blind hole in the other of the first conveyor and the second conveyor.

The vacuum chamber may include a door. The reflow soldering oven may include a door opening mechanism that is configured to move the door between: an open position, in which an item may be conveyed between the first conveyor and the second conveyor, and a closed position, in which the first conveyor and the second conveyor are separated by the door.

The conveyor alignment mechanism may be operably connected to the door opening mechanism such that when the door is moved from the closed position to the open position, the conveyor alignment mechanism moves the alignment member from the first position to the second position.

The conveyor alignment mechanism may be configured to move the alignment member from the second position to the first position when the door is moved from the open position to the closed position.

The alignment member may be configured to reciprocatingly move between the first position and the second position.

In examples of the invention, the door opening mechanism may be configured to reciprocatingly move the door between the open position and the closed position in a door opening plane, which door opening plane is perpendicular to an alignment member plane in which the alignment member moves between the first position and the second position.

The conveyor alignment mechanism may include a connector. The connector may include a first end and an opposing second end. The first end of the connector may be operably coupled to the alignment member. The second end of the connector may be operably coupled to the door opening mechanism such that movement of the door opening mechanism causes movement of the alignment member.

The first end of the connector may be configured to move with the alignment member in the alignment member plane. In use, the first end of the connector may move with the alignment member in the alignment member plane.

The second end of the connector may be configured to move with the door opening mechanism in the door opening plane. In use, the second end of the connector may move with the door opening mechanism in the door opening plane.

The door opening mechanism may include a channel. The channel may extend through at least a portion of the door opening mechanism. The channel may be configured to receive the alignment member. The alignment member may be configured to reciprocatingly move between the first conveyor and the second conveyor through the channel.

In examples, the reflow soldering oven may include an actuator. The actuator may be configured to move the door between the open position and the closed position. The actuator may thus move the conveyor alignment mechanism to hold the first conveyor and the second conveyor in the aligned configuration when the door is in the open position and release the first conveyor and the second conveyor from the aligned configuration when the door moves from the open position to the closed position.

In examples, the door may be an entrance door. The entrance door may be the door through which items are conveyed into the vacuum chamber.

The vacuum chamber may include an exit door. The entrance door may be the door through which items are conveyed out of the vacuum chamber.

The first conveyor may be an entrance conveyor. The first conveyor may be positioned outside of the vacuum chamber adjacent the entrance door.

The reflow soldering oven may include a third conveyor. The third conveyor may be positioned outside of the vacuum chamber adjacent the exit door. The third conveyor may thus be a third exit conveyor.

The door opening mechanism may be a first door opening mechanism. The reflow soldering oven may include a second door opening mechanism. The second door opening mechanism may be configured to move the exit door between an open position, in which an item may be conveyed between the second conveyor and the third conveyor, and a closed position, in which the second conveyor and the third conveyor are separated by the exit door.

The conveyor alignment mechanism may be a first conveyor alignment mechanism. The reflow soldering oven may include a second conveyor alignment mechanism that is operably connected to the second door opening mechanism and is configured to hold the second conveyor and the third conveyor in an aligned configuration when the exit door is in the open position.

According to the present invention there is provided a reflow soldering oven including a vacuum chamber having a door opening mechanism. The reflow soldering oven includes a conveyor alignment mechanism that is operably connected to the door opening mechanism to ensure that a conveyor on the outside of the vacuum chamber is correctly and reliably aligned with a conveyor on the inside of the vacuum chamber. The invention thus improves the transfer of items, for example circuit boards, between adjacent conveyors in a reflow soldering oven, in particular reflow soldering ovens that include a vacuum chamber. Advantageously, this improves the efficiency of reflow soldering processes and reduces wastage of components and minimises machine downtime.

The conveyor alignment mechanism may be configured to ensure that a side rail of a conveyor on the outside of the vacuum chamber is aligned with a side rail, for example a corresponding side rail, of a conveyor on the inside of the vacuum chamber.

The side rail of the conveyor on the outside of the vacuum chamber may have a longitudinal axis. The side rail of the conveyor on the inside of the vacuum chamber may have a longitudinal axis. The conveyor alignment mechanism may be configured to ensure that the longitudinal axis of the conveyor on the outside of the vacuum chamber is aligned with the longitudinal axis of the conveyor on the inside of the vacuum chamber.

In other words, the conveyor alignment mechanism enables the side rail of the conveyor on the outside of the vacuum chamber to be aligned with the corresponding side rail of the conveyor on the inside of the vacuum chamber in a length-wise direction.

The side rail of the conveyor on the outside of the vacuum chamber may be a first side rail. The conveyor on the outside of the vacuum chamber may have a second side rail. The first side rail may be on a first side of the conveyor on the outside of the vacuum chamber and the second side rail may be on a second side of the conveyor on the outside of the vacuum chamber.

The side rail of the conveyor on the inside of the vacuum chamber may be a first side rail. The conveyor on the inside of the vacuum chamber may have a second side rail. The first side rail may be on a first side of the conveyor on the inside of the vacuum chamber and the second side rail may be on a second side of the conveyor on the inside of the vacuum chamber.

The reflow soldering oven may include a conveyor width adjustment mechanism that is configured to enable a spacing between the first side rail and the second side rail of the conveyor on the outside of the vacuum chamber to be adjusted.

The reflow soldering oven may thus include a width adjustment mechanism in addition to a conveyor alignment mechanism.

The spacing between the first side rail and the second side rail of the conveyor extends by an adjustable distance which defines a width of the conveyor.

In other words, the conveyor width adjustment mechanism enables the width of the conveyor on the outside of the vacuum chamber to be adjusted, for example in order to accommodate items of different sizes.

Additionally or alternatively, the conveyor width adjustment mechanism may be configured to enable a spacing between the first side rail and the second side rail of the conveyor on the inside of the vacuum chamber to be adjusted.

In other words, the conveyor width adjustment mechanism may enable the width of the conveyor on the inside of the vacuum chamber to be adjusted, for example in order to accommodate items of different sizes.

The conveyor width adjustment mechanism may be configured to enable alignment of the first and second side rails of the conveyor on the outside of the vacuum chamber with the first and second side rails of the conveyor on the inside of the vacuum chamber in a width-wise direction.

The operable connection between the conveyor alignment mechanism and the door opening mechanism may be a mechanical connection, for example a direct mechanical connection between a component of the conveyor alignment mechanism and a component of the door opening mechanism.

In examples of the invention, the mechanical connection between the conveyor alignment mechanism and the door opening mechanism may be an indirect mechanical connection. In other words a component of the conveyor alignment mechanism may be connected to a component of the door opening mechanism via one or more other components.

Alternatively, the conveyor alignment mechanism may be operably connected to the door opening mechanism via a control system including one or more sensor, for example where in the one or more sensor is configured to sense a characteristic of the door opening mechanism (for example a position of the door opening mechanism) and to relay a signal corresponding to the characteristic to a controller associated with the conveyor alignment mechanism (for example a signal corresponding to the position of the door opening mechanism to a controller associated with the conveyor alignment mechanism).

According to an aspect of the invention there is provided a reflow soldering oven for soldering electronic circuit boards, the reflow soldering oven comprising a vacuum chamber; a first conveyor that is positioned outside of the vacuum chamber; and a second conveyor that is positioned inside the vacuum chamber. The vacuum chamber comprises a door opening mechanism that is configured to move a door between an open position, in which the vacuum chamber is open, and a closed position, in which the vacuum chamber is sealed closed by the door. The reflow soldering oven comprises a conveyor alignment mechanism that is configured to hold the first conveyor and the second conveyor in an aligned configuration when the door is in the open position.

The invention beneficially ensures that a conveyor on the outside of the vacuum chamber is correctly and reliably aligned with a conveyor on the inside of the vacuum chamber when the transfer of items, for example circuit boards, from the outside the vacuum chamber to the inside of the vacuum chamber, or from the inside of the vacuum chamber to the outside of the vacuum chamber, is required. The invention thus improves the transfer of items, for example circuit boards, between adjacent conveyors in a reflow soldering oven that includes a vacuum chamber and hence improving the efficiency of reflow soldering processes.

The conveyor alignment mechanism may be configured to ensure that a side rail of a conveyor on the outside of the vacuum chamber is aligned with a side rail, for example a corresponding side rail, of a conveyor on the inside of the vacuum chamber.

In other words, the conveyor alignment mechanism may be configured to ensure that a side rail of the first conveyor is aligned with a side rail, for example a corresponding side rail, of the second conveyor.

The side rail of the conveyor on the outside of the vacuum chamber (i.e. the side rail of the first conveyor) may have a longitudinal axis. The side rail of the conveyor on the inside of the vacuum chamber (i.e. the side rail of the second conveyor) may have a longitudinal axis. The conveyor alignment mechanism may be configured to ensure that the longitudinal axis of the conveyor on the outside of the vacuum chamber (i.e. the longitudinal axis of the first conveyor) is aligned with the longitudinal axis of the conveyor on the inside of the vacuum chamber (i.e. the longitudinal axis of the second conveyor).

In other words, the conveyor alignment mechanism enables the side rail of the conveyor on the outside of the vacuum chamber (i.e. the side rail of the first conveyor) to be aligned with the side rail of the conveyor on the inside of the vacuum chamber (i.e. the side rail of the second conveyor) in a length-wise direction.

The side rail of the conveyor on the outside of the vacuum chamber may be a first side rail. The conveyor on the outside of the vacuum chamber may have a second side rail. The first side rail may be on a first side of the conveyor on the outside of the vacuum chamber and the second side rail may be on a second side of the conveyor on the outside of the vacuum chamber.

In other words, the first conveyor may have a first rail and an opposing second rail. The first rail and the opposing second rail may be spaced apart by a distance corresponding to a width of the first conveyor.

The side rail of the conveyor on the inside of the vacuum chamber may be a first side rail. The conveyor on the inside of the vacuum chamber may have a second side rail. The first side rail may be on a first side of the conveyor on the inside of the vacuum chamber and the second side rail may be on a second side of the conveyor on the inside of the vacuum chamber.

In other words, the second conveyor may have a first rail and an opposing second rail. The first rail and the opposing second rail may be spaced apart by a distance corresponding to a width of the second conveyor.

The reflow soldering oven may include a conveyor width adjustment mechanism that is configured to enable a spacing between the first side rail and the second side rail of the conveyor on the outside of the vacuum chamber (i.e. the first conveyor) to be adjusted.

In other words, the conveyor width adjustment mechanism enables the width of the conveyor on the outside of the vacuum chamber (i.e. the first conveyor) to be adjusted, for example in order to accommodate items of different sizes.

Additionally or alternatively, the conveyor width adjustment mechanism may be configured to enable a spacing between the first side rail and the second side rail of the conveyor on the inside of the vacuum chamber (i.e. the second conveyor) to be adjusted.

In other words, the conveyor width adjustment mechanism may enable the width of the conveyor on the inside of the vacuum chamber (i.e. the second conveyor) to be adjusted, for example in order to accommodate items of different sizes.

The conveyor width adjustment mechanism may be configured to enable alignment of the first and second side rails of the conveyor on the outside of the vacuum chamber (i.e. the first conveyor) with the first and second side rails of the conveyor on the inside of the vacuum chamber (i.e. the second conveyor) in a width-wise direction.

The operable connection between the conveyor alignment mechanism and the door opening mechanism may be a mechanical connection, for a direct mechanical connection between a component of the conveyor alignment mechanism and a component of the door opening mechanism.

In examples of the invention, the mechanical connection between the conveyor alignment mechanism and the door opening mechanism may be an indirect mechanical connection. In other words a component of the conveyor alignment mechanism may be connected to a component of the door opening mechanism via one or more other components.

Alternatively, the conveyor alignment mechanism may be operably connected to the door opening mechanism via a control system including one or more sensor, for example where in the one or more sensor is configured to sense a characteristic of the door opening mechanism (for example a position of the door opening mechanism) and to relay a signal corresponding to the characteristic to a controller associated with the conveyor alignment mechanism (for example a signal corresponding to the position of the door opening mechanism to a controller associated with the conveyor alignment mechanism).

According to an aspect of the invention there is provided a reflow soldering oven for soldering electronic circuit boards, the reflow soldering oven comprising a vacuum chamber comprising a door; a first conveyor that is positioned outside of the vacuum chamber; and a second conveyor that is positioned inside the vacuum chamber. The door comprises a door opening mechanism that is configured to move the door between an open position, in which an item may be conveyed between the first conveyor and the second conveyor, and a closed position, in which the first conveyor and the second conveyor are separated by the door. The reflow soldering oven comprises a conveyor alignment mechanism that is operably connected to the door opening mechanism and is configured to hold the first conveyor and the second conveyor in an aligned configuration when the door is in the open position.

The invention thus improves the transfer of items, for example circuit boards, between adjacent conveyors in a reflow soldering oven that includes a vacuum chamber and hence improving the efficiency of reflow soldering processes.

The conveyor alignment mechanism may be configured to ensure that a side rail of a conveyor on the outside of the vacuum chamber is aligned with a side rail, for example a corresponding side rail, of a conveyor on the inside of the vacuum chamber.

In other words, the conveyor alignment mechanism may be configured to ensure that a side rail of the first conveyor is aligned with a side rail, for example a corresponding side rail, of the second conveyor.

The side rail of the conveyor on the outside of the vacuum chamber (i.e. the side rail of the first conveyor) may have a longitudinal axis. The side rail of the conveyor on the inside of the vacuum chamber (i.e. the side rail of the second conveyor) may have a longitudinal axis. The conveyor alignment mechanism may be configured to ensure that the longitudinal axis of the conveyor on the outside of the vacuum chamber (i.e. the longitudinal axis of the first conveyor) is aligned with the longitudinal axis of the conveyor on the inside of the vacuum chamber (i.e. the longitudinal axis of the second conveyor).

In other words, the conveyor alignment mechanism enables the side rail of the conveyor on the outside of the vacuum chamber (i.e. the side rail of the first conveyor) to be aligned with the side rail of the conveyor on the inside of the vacuum chamber (i.e. the side rail of the second conveyor) in a length-wise direction.

The side rail of the conveyor on the outside of the vacuum chamber may be a first side rail. The conveyor on the outside of the vacuum chamber may have a second side rail. The first side rail may be on a first side of the conveyor on the outside of the vacuum chamber and the second side rail may be on a second side of the conveyor on the outside of the vacuum chamber.

In other words, the first conveyor may have a first rail and an opposing second rail. The first rail and the opposing second rail may be spaced apart by a distance corresponding to a width of the first conveyor.

The side rail of the conveyor on the inside of the vacuum chamber may be a first side rail. The conveyor on the inside of the vacuum chamber may have a second side rail. The first side rail may be on a first side of the conveyor on the inside of the vacuum chamber and the second side rail may be on a second side of the conveyor on the inside of the vacuum chamber.

In other words, the second conveyor may have a first rail and an opposing second rail. The first rail and the opposing second rail may be spaced apart by a distance corresponding to a width of the second conveyor.

The reflow soldering oven may include a conveyor width adjustment mechanism that is configured to enable a spacing between the first side rail and the second side rail of the conveyor on the outside of the vacuum chamber (i.e. the first conveyor) to be adjusted.

In other words, the conveyor width adjustment mechanism enables the width of the conveyor on the outside of the vacuum chamber (i.e. the first conveyor) to be adjusted, for example in order to accommodate items of different sizes.

Additionally or alternatively, the conveyor width adjustment mechanism may be configured to enable a spacing between the first side rail and the second side rail of the conveyor on the inside of the vacuum chamber (i.e. the second conveyor) to be adjusted.

In other words, the conveyor width adjustment mechanism may enable the width of the conveyor on the inside of the vacuum chamber (i.e. the second conveyor) to be adjusted, for example in order to accommodate items of different sizes.

The conveyor width adjustment mechanism may be configured to enable alignment of the first and second side rails of the conveyor on the outside of the vacuum chamber (i.e. the first conveyor) with the first and second side rails of the conveyor on the inside of the vacuum chamber (i.e. the second conveyor) in a width-wise direction.

The operable connection between the conveyor alignment mechanism and the door opening mechanism may be a mechanical connection, for a direct mechanical connection between a component of the conveyor alignment mechanism and a component of the door opening mechanism.

In examples of the invention, the mechanical connection between the conveyor alignment mechanism and the door opening mechanism may be an indirect mechanical connection. In other words a component of the conveyor alignment mechanism may be connected to a component of the door opening mechanism via one or more other components.

Alternatively, the conveyor alignment mechanism may be operably connected to the door opening mechanism via a control system including one or more sensor, for example where in the one or more sensor is configured to sense a characteristic of the door opening mechanism (for example a position of the door opening mechanism) and to relay a signal corresponding to the characteristic to a controller associated with the conveyor alignment mechanism (for example a signal corresponding to the position of the door opening mechanism to a controller associated with the conveyor alignment mechanism).

The conveyor alignment mechanism may be configured to release the first conveyor and the second conveyor from the aligned configuration when the door is moved from the open position to the closed position.

In this way, the conveyor alignment mechanism does not interfere with correct closing of the door of the vacuum chamber, which might prevent the required pressure reduction to prevent the formation of voids in the solder.

The conveyor alignment mechanism may be configured to release the or each side rail of the first conveyor and the or each side rail of the second conveyor from the aligned configuration (in which the or rail of the first conveyor is longitudinally aligned with the or each corresponding rail of the second conveyor) when the door is moved from the open position to the closed position.

The conveyor alignment mechanism, e.g. a component of the conveyor alignment mechanism, may be configured to reciprocatingly move in between the first conveyor and the second conveyor. The conveyor alignment mechanism, e.g. the component of the conveyor alignment mechanism, may, for example, move forwards and backwards between the first conveyor and the second conveyor. The reciprocating movement of the conveyor alignment mechanism, e.g the reciprocating movement of the component of the conveyor alignment mechanism, may be a back-and-forth linear motion between the first conveyor and the second conveyor.

The reciprocating movement may include a first stroke, in which the conveyor alignment mechanism (e.g. the component of the conveyor alignment mechanism) is moved in a first direction from one of the first conveyor and the second conveyor towards the other of the first conveyor and the second conveyor, and a second stroke, in which the conveyor alignment mechanism (e.g. the component of the conveyor alignment mechanism) is moved in an opposing second direction from the other of the first conveyor and the second conveyor back towards the one of the first conveyor and the second conveyor. The first stroke and the second stroke of the reciprocating movement of the conveyor alignment mechanism (e.g. the first stroke and the second stroke of the reciprocating movement of the component of the conveyor alignment mechanism) may have a predetermined distance. The predetermined distance may be fixed.

The conveyor alignment mechanism may include an alignment member that is operably coupled to one of the first conveyor and the second conveyor. The alignment member may be configured to reciprocatingly move between the first conveyor and the second conveyor.

The alignment member may be the component of the conveyor alignment mechanism that is moved in the first direction (in the first stroke) from the one of the first conveyor and the second conveyor toward the other of the first conveyor and the second conveyor, and is moved in the opposing second direction (in the second stroke) from the other of the first conveyor and the second conveyor back toward the one of the first conveyor and the second conveyor.

The alignment member may be slidingly coupled to the one of the first conveyor and the second conveyor.

The alignment member may, in examples, move forwards and backwards between the first conveyor and the second conveyor. The reciprocating movement of the alignment member may be a back-and-forth linear motion between the first conveyor and the second conveyor.

The reciprocating movement may include a first stroke, in which the alignment member is moved in a first direction from the one of the first conveyor and the second conveyor towards the other of the first conveyor and the second conveyor, and a second stroke, in which the alignment member is moved in an opposing second direction from the other of the first conveyor and the second conveyor back towards the one of the first conveyor and the second conveyor. The first stroke and the second stroke of the reciprocating movement of the alignment member may have a predetermined distance. The predetermined distance may be fixed.

The predetermined distance of the first stroke and the second stroke of the reciprocating movement of the alignment member may be the same as the predetermined distance of the first stroke and the second stroke of the reciprocating movement of the conveyor alignment mechanism.

The alignment member may have a proximal end at which it is operably connected to the one of the first conveyor and the second conveyor and an opposing distal end. The reciprocating movement of the alignment member may be such that when the alignment member is moved relative to the one of the first conveyor and the second conveyor in a first direction (for example a direction of the first stroke), the distal end of the alignment member moves closer to the other of the first conveyor and the second conveyor and when the alignment member is moved relative to the one of the first conveyor and the second conveyor in a second direction (for example a direction of the second stroke), the distal end of the alignment member moves away from the other of the first conveyor and the second conveyor.

The alignment member, for example the distal end of the alignment member, may be configured to move towards and engage the other of the first conveyor and the second conveyor when the door is in the open position.

The alignment member, for example the distal end of the alignment member, may be configured to retract (i.e. move away from) from the other of the first conveyor and the second conveyor when the door is moved from the open position to the closed position.

The alignment member may, in examples be an alignment pin or an alignment bar. The alignment member may include a telescopic member that reciprocates within a body of the conveyor alignment mechanism.

The other of the first conveyor and the second conveyor may include an opening within which the alignment member is at least partially received when the first conveyor and the second conveyor are in the aligned configuration.

The opening may form part of a blind hole in the other of the first conveyor and the second conveyor. The blind hole may be configured to receive a part, for example the distal end, of the alignment member. The blind hole may have a predetermined length that is selected to control the distance that the alignment member can travel towards the other of the first conveyor and the second conveyor.

The conveyor alignment mechanism may include a conveyor alignment actuator that is configured to move the component (e.g. the alignment member) of the conveyor alignment mechanism in the first and second directions.

The conveyor alignment actuator may be a linear actuator.

The door opening mechanism may be configured to reciprocatingly move the door between the open position and the closed position in a door opening plane, which door opening plane is perpendicular to an alignment member plane within which the alignment member reciprocates.

The conveyor alignment mechanism may be directly connected, or coupled, to the door opening mechanism such that opening and closing of the door of the vacuum chamber causes movement of the component, for example the alignment member, of the conveyor alignment mechanism.

The conveyor alignment mechanism may be mechanically coupled or connected to the door opening mechanism.

The conveyor alignment mechanism may include a connector, for example a connector including a first end and an opposing second end, wherein the first end of the connector is operably coupled to the alignment member and the second end of the connector is operably coupled to the door opening mechanism such that movement of the door opening mechanism causes movement of the alignment member.

The alignment member may include an alignment member slot that is configured to receive the first end of the connector.

The door opening mechanism may include a door opening mechanism slot that is configured to receive the second end of the connector.

The first end of the connector may be configured to move with the alignment member in the alignment member plane and the second end of the connector may be configured to move with the door opening mechanism in the door opening plane.

The door opening mechanism may include a channel, for example an enclosed channel. The channel may extends through at least a portion of the door opening mechanism and is configured to receive the alignment member. The alignment member may be configured to reciprocatingly move between the first conveyor and the second conveyor through the channel.

The reflow soldering oven may include an actuator, for example a door opening actuator. The actuator, for example the door opening actuator, may be configured to move the door between the open position and the closed position. In this way the conveyor alignment mechanism may be moved to hold the first conveyor and the second conveyor, for example the or each rail of the first conveyor and the or each rail of the second conveyor, in the aligned configuration (i.e. the longitudinally aligned configuration) when the door is in the open position and release the first conveyor and the second conveyor, for example the or each rail of the first conveyor and the or each rail of the second conveyor, from the aligned configuration when the door moves from the open position to the closed position.

The actuator, for example the door opening actuator, may be any one of a hydraulic actuator, or a piezoelectric actuator, or a linear actuator, or a pneumatic actuator, or a mechanical actuator, or an electromagnetic actuator, or an electric actuator, or a solenoid actuator.

The door may be an entrance door, for example a door at an entrance opening of the vacuum chamber. The circuit board may, for example, be conveyed from the first conveyor to the second conveyor into the vacuum chamber through the entrance door.

The vacuum chamber may include a further door. The further door may be an exit door, for example a door at an exit opening of the vacuum chamber. The circuit board may be, for example, conveyed from the second conveyor to a third conveyor of the reflow soldering oven that is outside the vacuum chamber through the exit door.

The first conveyor may thus be referred to as an entrance conveyor. The entrance conveyor may be positioned outside of the vacuum chamber adjacent the entrance door.

Similarly, the third conveyor may be referred to as an exit conveyor. The exit conveyor may be positioned outside of the vacuum chamber adjacent the exit door.

The second conveyor, which is positioned within the vacuum chamber, may thus be referred to as a vacuum conveyor. The second conveyor may be positioned between the entrance door and the exit door of the vacuum chamber. One end of the second conveyor may be positioned adjacent or close to an end of the first conveyor. An opposing end of the second conveyor may be positioned adjacent or close to an end of the third conveyor. In other words, the second conveyor may be positioned between the first conveyor and the third conveyor.

The conveyor alignment mechanism may be configured to enable a side rail of the third conveyor to be aligned with a side rail, for example a corresponding side rail, of the second conveyor.

The side rail of the third conveyor may have a longitudinal axis. The corresponding side rail of the second conveyor may have a longitudinal axis. The conveyor alignment mechanism may be configured to ensure that the longitudinal axis of the third conveyor is aligned with the longitudinal axis of the second conveyor in a length-wise direction.

The side rail of the third conveyor may be a first side rail. The third conveyor may have a second side rail. The first side rail may be on a first side of the third conveyor and the second side rail may be on a second side of the third conveyor.

The width adjustment mechanism may be configured to enable a spacing between the first side rail and the second side rail of the third conveyor.

In other words, the conveyor width adjustment mechanism may enable the width of the third conveyor to be adjusted, for example in order to accommodate items of different sizes.

The conveyor width adjustment mechanism may be thus configured to enable alignment of the first and second side rails of the third conveyor with the first and second side rails of the second conveyor in a width-wise direction.

The door opening mechanism may be a first door opening mechanism. The reflow soldering oven may include a second door opening mechanism. The first door opening mechanism may be associated with, for example, operably connected to one of the entrance door and the exit door of the vacuum chamber. The second door opening mechanism may be associated with, for example, operably connected to the other of the entrance door and the exit door of the vacuum chamber.

The first door opening mechanism may be, for example, operably connected to the entrance door.

The second door opening mechanism may be operably connected to the exit door. The second door opening mechanism may be, for example, configured to move the exit door between an open position, in which an item may be conveyed between the second conveyor (e.g. the vacuum conveyor) and the third conveyor (e.g. the exit conveyor), and a closed position, in which the second conveyor and the third conveyor are separated by the exit door.

The conveyor alignment mechanism may be a first conveyor alignment mechanism. The first conveyor alignment mechanism may be operably connected, e.g. directly or indirectly operably connected, to the one of the first door opening mechanism and the second door opening mechanism.

The reflow soldering oven may include a second conveyor alignment mechanism. The second conveyor alignment mechanism may be operably connected to the other of the first door opening mechanism and the second door opening mechanism.

In embodiments of the invention, the first conveyor alignment mechanism may be operably connected to the first door opening mechanism and the second conveyor alignment mechanism may be operably connected to the second door opening mechanism.

The second conveyor alignment mechanism may be, for example, configured to hold the second conveyor and the third conveyor in an aligned configuration (i.e. the longitudinally aligned configuration) when the exit door is in the open position.

The second conveyor alignment mechanism may be configured to release the second conveyor and the third conveyor from the aligned configuration when the exit door is moved from the open position to the closed position.

In this way, the second conveyor alignment mechanism does not interfere with correct closing of the exit door of the vacuum chamber, which might prevent the required pressure reduction to prevent the formation of voids in the solder.

The second conveyor alignment mechanism may be configured to reciprocatingly move in between the second conveyor and the third conveyor. The second conveyor alignment mechanism may, for example, move forwards and backwards between the second conveyor and the third conveyor. The reciprocating movement of the second conveyor alignment mechanism may be a back-and-forth linear motion between the second conveyor and the third conveyor.

The reciprocating movement may include a first stroke, in which the second conveyor alignment mechanism is moved in a first direction from one of the second conveyor and the third conveyor towards the other of the second conveyor and the third conveyor, and a second stroke, in which the second conveyor alignment mechanism is moved in an opposing second direction from the other of the second conveyor and the third conveyor back towards the one of the second conveyor and the third conveyor. The first stroke and the second stroke of the reciprocating movement of the second conveyor alignment mechanism may have a predetermined distance. The predetermined distance may be fixed.

The second conveyor alignment mechanism may include an alignment member that is operably coupled to one of the second conveyor and the third conveyor. The alignment member of the second conveyor alignment mechanism may be configured to reciprocatingly move between the second conveyor and the third conveyor

The alignment member of the second conveyor alignment mechanism may be slidingly coupled to the one of the second conveyor and the third conveyor.

The alignment member of the second conveyor alignment mechanism may, in examples, move forwards and backwards between the second conveyor and the third conveyor The reciprocating movement of the alignment member of the second conveyor alignment mechanism may be a back-and-forth linear motion between the second conveyor and the third conveyor.

The reciprocating movement may include a first stroke, in which the alignment member of the second conveyor alignment mechanism is moved in a first direction from the one of the second conveyor and the third conveyor towards the other of the second conveyor and the third conveyor and a second stroke, in which the alignment member of the second conveyor alignment mechanism is moved in an opposing second direction from the other of the second conveyor and the third conveyor back towards the one of the second conveyor and the third conveyor. The first stroke and the second stroke of the reciprocating movement of the alignment member of the second conveyor alignment mechanism may have a predetermined distance. The predetermined distance may be fixed.

The predetermined distance of the first stroke and the second stroke of the reciprocating movement of the alignment member of the second conveyor alignment mechanism may be the same as the predetermined distance of the first stroke and the second stroke of the reciprocating movement of the second conveyor alignment mechanism.

The alignment member of the second conveyor alignment mechanism may have a proximal end at which it is operably connected to the one of the second conveyor and the third conveyor and an opposing distal end. The reciprocating movement of the alignment member of the second conveyor alignment mechanism may be such that when the alignment member of the second conveyor alignment mechanism is moved relative to the one of the second conveyor and the third conveyor in a first direction (for example a direction of the first stroke), the distal end of the alignment member of the second conveyor alignment mechanism moves closer to the other of the second conveyor and the third conveyor and when the alignment member of the second conveyor alignment mechanism is moved relative to the one of the second conveyor and the third conveyor in a second direction (for example a direction of the second stroke), the distal end of the alignment member of the second conveyor alignment mechanism moves away from the other of the second conveyor and the third conveyor.

The alignment member of the second conveyor alignment mechanism, for example the distal end of the alignment member of the second conveyor alignment mechanism, may be configured to move towards and engage the other of the second conveyor and the third conveyor when the exit door is in the open position.

The alignment member of the second conveyor alignment mechanism, for example the distal end of the alignment member of the second conveyor alignment mechanism, may be configured to retract (i.e. move away from) from the other of the second conveyor and the third conveyor when the exit door is moved from the open position to the closed position.

The alignment member of the second conveyor alignment mechanism may, in examples be an alignment pin or an alignment bar. The alignment member of the second conveyor alignment mechanism may include a telescopic member that reciprocates within a body of the second conveyor alignment mechanism.

The other of the second conveyor and the third conveyor may include an opening within which the alignment member of the second conveyor alignment mechanism is at least partially received when the second conveyor and the third conveyor are in the aligned configuration.

The opening may form part of a blind hole in the other of the second conveyor and the third conveyor. The blind hole may be configured to receive a part, for example the distal end, of the alignment member of the second conveyor alignment mechanism. The blind hole may have a predetermined length that is selected to control the distance that the alignment member of the second conveyor alignment mechanism can travel towards the other of the second conveyor and the third conveyor.

The second door opening mechanism may be configured to reciprocatingly move the exit door between the open position and the closed position in an exit door opening plane, which exit door opening plane is perpendicular to a second alignment member plane within which the alignment member of the second conveyor alignment mechanism reciprocates.

The second conveyor alignment mechanism may include a connector, for example a connector including a first end and an opposing second end, wherein the first end of the connector of the second conveyor alignment mechanism is operably coupled to the alignment member of the second conveyor alignment mechanism and the second end of the connector of the second conveyor alignment mechanism is operably coupled to the second door opening mechanism such that movement of the second door opening mechanism causes movement of the alignment member of the second conveyor alignment mechanism.

The alignment member of the second conveyor alignment mechanism may include an alignment member slot that is configured to receive the first end of the connector of the second conveyor alignment mechanism.

The second door opening mechanism may include a door opening mechanism slot that is configured to receive the second end of the connector of the second conveyor alignment mechanism.

The first end of the connector of the second conveyor alignment mechanism may be configured to move with the alignment member of the second conveyor alignment mechanism in the second alignment member plane and the second end of the connector of the second conveyor alignment mechanism may be configured to move with the second door opening mechanism in the second door opening plane.

The second door opening mechanism may include a channel, for example an enclosed channel. The channel may extend through at least a portion of the second door opening mechanism and may be configured to receive the alignment member of the second conveyor alignment mechanism. The alignment member of the second conveyor alignment mechanism may be configured to reciprocatingly move between the second conveyor and the third conveyor through the channel.

The actuator of the reflow soldering oven may be a first actuator. The reflow soldering oven may include a further actuator. The further actuator may be configured to move the exit door between the open position and the closed position. In this way the second conveyor alignment mechanism may be moved to hold the second conveyor and the third conveyor in the aligned configuration when the exit door is in the open position and release the second conveyor and the third conveyor from the aligned configuration when the exit door moves from the open position to the closed position.

The first conveyor, the second conveyor, the third conveyor, the first door opening mechanism, the second door opening mechanism, the first conveyor alignment mechanism and the second conveyor alignment mechanism may form a first conveyor path through the reflow soldering oven.

The reflow soldering oven may include a second conveyor path. The second conveyor path may run between the entrance door and the exit door of the vacuum chamber. The second conveyor path may be parallel to the first conveyor path.

The reflow soldering oven may include a fourth conveyor, a fifth conveyor, a sixth conveyor, a third door opening mechanism, a fourth door opening mechanism, a third conveyor alignment mechanism and a fourth conveyor alignment mechanism.

The fourth conveyor, the fifth conveyor, the sixth conveyor, the third door opening mechanism, the fourth door opening mechanism, the third conveyor alignment mechanism and the fourth conveyor alignment mechanism may together form the second conveyor path of the reflow soldering oven.

The fourth conveyor may be a conveyor as described in relation to the first conveyor. The fourth conveyor may be referred to as a second first conveyor and/or as a second entrance conveyor. The fourth conveyor may be outside the vacuum chamber. The fourth conveyor may be adjacent the entrance door of the vacuum chamber. The fourth conveyor may be parallel to the first conveyor.

The fifth conveyor may be a conveyor as described in relation to the second conveyor. The fifth conveyor may be referred to as a second second conveyor and/or as a second vacuum conveyor. The fifth conveyor may be inside the vacuum chamber. The fifth conveyor may be positioned between the entrance door and the exit door of the vacuum chamber. One end of the fifth conveyor may be positioned adjacent or close to an end of the fourth conveyor. An opposing end of the fifth conveyor may be positioned adjacent or close to an end of the sixth conveyor. In other words, the fifth conveyor may be positioned between the fourth conveyor and the sixth conveyor. The fifth conveyor may be parallel to the second conveyor.

The sixth conveyor may be a conveyor as described in relation to the third conveyor. The sixth conveyor may be referred to as a second third conveyor and/or as a second exit conveyor. The sixth conveyor may be outside the vacuum chamber. The sixth conveyor may be adjacent the exit door of the vacuum chamber. The sixth conveyor may be parallel to the third conveyor.

The third door opening mechanism may be a door opening mechanism as described in relation to the first door opening mechanism. The third door opening mechanism may be referred ti as a second first door opening mechanism. The third door opening mechanism may be operably connected to the entrance door of the vacuum chamber. The first door opening mechanism and the third door opening mechanism may together form part of an entrance door opening mechanism. The first door opening mechanism and the third door opening mechanism may be operably coupled to the entrance door of the vacuum chamber. The first door opening mechanism and the third door opening mechanism may be operably coupled to each other.

The third conveyor alignment mechanism may be similar to the first conveyor alignment mechanism. The third conveyor alignment mechanism may be operably connected to the third door opening mechanism and may be configured to hold the fourth conveyor and the fifth conveyor in an aligned configuration when the entrance door is in the open position.

The third conveyor alignment mechanism may be configured to release the fourth conveyor and the fifth conveyor from the aligned configuration when the entrance door is moved from the open position to the closed position.

In this way, the third conveyor alignment mechanism does not interfere with correct closing of the entrance door of the vacuum chamber, which might prevent the required pressure reduction to prevent the formation of voids in the solder.

The third conveyor alignment mechanism may be configured to reciprocatingly move in between the fourth conveyor and the fifth conveyor. The third conveyor alignment mechanism may, for example, move forwards and backwards between the fourth conveyor and the fifth conveyor. The reciprocating movement of the third conveyor alignment mechanism may be a back-and-forth linear motion between the fourth conveyor and the fifth conveyor.

The reciprocating movement may include a first stroke, in which the third conveyor alignment mechanism is moved in a first direction from one of the fourth conveyor and the fifth conveyor towards the other of the fourth conveyor and the fifth conveyor, and a second stroke, in which the third conveyor alignment mechanism is moved in an opposing second direction from the other of the fourth conveyor and the fifth conveyor back towards the one of the fourth conveyor and the fifth conveyor. The first stroke and the second stroke of the reciprocating movement of the third conveyor alignment mechanism may have a predetermined distance. The predetermined distance may be fixed.

The third conveyor alignment mechanism may include an alignment member that is operably coupled to one of the fourth conveyor and the fifth conveyor. The alignment member of the third conveyor alignment mechanism may be configured to reciprocatingly move between the fourth conveyor and the fifth conveyor.

The alignment member of the third conveyor alignment mechanism may be slidingly coupled to the one of the fourth conveyor and the fifth conveyor.

The alignment member of the third conveyor alignment mechanism may, in examples, move forwards and backwards between the fourth conveyor and the fifth conveyor. The reciprocating movement of the alignment member of the third conveyor alignment mechanism may be a back-and-forth linear motion between the fourth conveyor and the fifth conveyor.

The reciprocating movement may include a first stroke, in which the alignment member of the third conveyor alignment mechanism is moved in a first direction from the one of the fourth conveyor and the fifth conveyor towards the other of the fourth conveyor and the fifth conveyor and a second stroke, in which the alignment member of the third conveyor alignment mechanism is moved in an opposing second direction from the other of the fourth conveyor and the fifth conveyor back towards the one of the fourth conveyor and the fifth conveyor. The first stroke and the second stroke of the reciprocating movement of the alignment member of the third conveyor alignment mechanism may have a predetermined distance. The predetermined distance may be fixed.

The predetermined distance of the first stroke and the second stroke of the reciprocating movement of the alignment member of the third conveyor alignment mechanism may be the same as the predetermined distance of the first stroke and the second stroke of the reciprocating movement of the third conveyor alignment mechanism.

The alignment member of the third conveyor alignment mechanism may have a proximal end at which it is operably connected to the one of the fourth conveyor and the fifth conveyor and an opposing distal end. The reciprocating movement of the alignment member of the third conveyor alignment mechanism may be such that when the alignment member is moved relative to the one of the fourth conveyor and the fifth conveyor in a first direction (for example a direction of the first stroke), the distal end of the alignment member is moved closer to the other of the fourth conveyor and the fifth conveyor and when the alignment member of the third conveyor alignment mechanism is moved relative to the one of the fourth conveyor and the fifth conveyor in a second direction (for example a direction of the second stroke), the distal end of the alignment member moves away from the other of the fourth conveyor and the fifth conveyor.

The alignment member of the third conveyor alignment mechanism, for example the distal end of the alignment member of the third conveyor alignment mechanism, may be configured to move towards and engage the other of the fourth conveyor and the fifth conveyor when the entrance door is in the open position.

The alignment member of the third conveyor alignment mechanism, for example the distal end of the alignment member of the third conveyor alignment mechanism, may be configured to retract (i.e. move away from) from the other of the fourth conveyor and the fifth conveyor when the entrance door is moved from the open position to the closed position.

The alignment member of the third conveyor alignment mechanism may, in examples be an alignment pin or an alignment bar. The alignment member of the third conveyor alignment mechanism may include a telescopic member that reciprocates within a body of the third conveyor alignment mechanism.

The other of the fourth conveyor and the fifth conveyor may include an opening within which the alignment member of the third conveyor alignment mechanism is at least partially received when the fourth conveyor and the fifth conveyor are in the aligned configuration.

The opening may form part of a blind hole in the other of the fourth conveyor and the fifth conveyor. The blind hole may be configured to receive a part, for example the distal end, of the alignment member of the third conveyor alignment mechanism. The blind hole may have a predetermined length that is selected to control the distance that the alignment member of the third conveyor alignment mechanism can travel towards the other of the fourth conveyor and the fifth conveyor.

The third door opening mechanism may be configured to reciprocatingly move the entrance door between the open position and the closed position in a second entrance door opening plane, which second entrance door opening plane is perpendicular to a third alignment member plane within which the alignment member of the third conveyor alignment mechanism reciprocates.

The third conveyor alignment mechanism may include a connector, for example a connector including a first end and an opposing second end, wherein the first end of the connector of the third conveyor alignment mechanism is operably coupled to the alignment member of the third conveyor alignment mechanism and the second end of the connector of the third conveyor alignment mechanism is operably coupled to the third door opening mechanism such that movement of the third door opening mechanism causes movement of the alignment member of the third conveyor alignment mechanism.

The alignment member of the third conveyor alignment mechanism may include an alignment member slot that is configured to receive the first end of the connector of the third conveyor alignment mechanism.

The third door opening mechanism may include a door opening mechanism slot that is configured to receive the second end of the connector of the third conveyor alignment mechanism.

The first end of the connector of the third conveyor alignment mechanism may be configured to move with the alignment member of the third conveyor alignment mechanism in the third alignment member plane and the second end of the connector may be configured to move with the second door opening mechanism in the second entrance door opening plane.

The third door opening mechanism may include a channel, for example an enclosed channel. The channel may extend through at least a portion of the third door opening mechanism and may be configured to receive the alignment member of the third conveyor alignment mechanism. The alignment member of the third conveyor alignment mechanism may be configured to reciprocatingly move between the fourth conveyor and the fifth conveyor through the channel.

As described above in relation to the first door opening mechanism, the reflow soldering oven includes a first actuator. The first actuator may be configured to move the entrance door between the open position and the closed position. In this way the third conveyor alignment mechanism may be moved to hold the fourth conveyor and the fifth conveyor in the aligned configuration when the entrance door is in the open position and release the fourth conveyor and the fifth conveyor from the aligned configuration when the entrance door moves from the open position to the closed position.

The fourth door opening mechanism may be a door opening mechanism as described in relation to the second door opening mechanism. The fourth door opening mechanism may be referred to as a second second door opening mechanism. The fourth door opening mechanism may be operably connected to the exit door of the vacuum chamber. The second door opening mechanism and the fourth door opening mechanism may together form part of an exit door opening mechanism. The second door opening mechanism and the fourth door opening mechanism may be operably coupled to the exit door of the vacuum chamber. The second door opening mechanism and the fourth door opening mechanism may be operably coupled to each other.

The fourth conveyor alignment mechanism may be similar to the second conveyor alignment mechanism. The fourth conveyor alignment mechanism may be operably connected to the fourth door opening mechanism and may be configured to hold the fifth conveyor and the sixth conveyor in an aligned configuration when the exit door is in the open position.

The fourth conveyor alignment mechanism may be configured to release the fifth conveyor and the sixth conveyor from the aligned configuration when the exit door is moved from the open position to the closed position.

In this way, the fourth conveyor alignment mechanism does not interfere with correct closing of the exit door of the vacuum chamber, which might prevent the required pressure reduction to prevent the formation of voids in the solder.

The fourth conveyor alignment mechanism may be configured to reciprocatingly move in between the fifth conveyor and the sixth conveyor. The fourth conveyor alignment mechanism may, for example, move forwards and backwards between the fifth conveyor and the sixth conveyor. The reciprocating movement of the fourth conveyor alignment mechanism may be a back-and-forth linear motion between the fifth conveyor and the sixth conveyor.

The reciprocating movement may include a first stroke, in which the fourth conveyor alignment mechanism is moved in a first direction from one of the fifth conveyor and the sixth conveyor towards the other of the fifth conveyor and the sixth conveyor, and a second stroke, in which the fourth conveyor alignment mechanisms is moved in an opposing second direction from the other of the fifth conveyor and the sixth conveyor back towards the one of the fifth conveyor and the sixth conveyor. The first stroke and the second stroke of the reciprocating movement of the fourth conveyor alignment mechanism may have a predetermined distance. The predetermined distance may be fixed.

The fourth conveyor alignment mechanism may include an alignment member that is operably coupled to one of the fifth conveyor and the sixth conveyor. The alignment member of the fourth conveyor alignment mechanism may be configured to reciprocatingly move between the fifth conveyor and the sixth conveyor.

The alignment member of the fourth conveyor alignment mechanism may be slidingly coupled to the one of the fifth conveyor and the sixth conveyor.

The alignment member of the fourth conveyor alignment mechanism may, in examples, move forwards and backwards between the fifth conveyor and the sixth conveyor. The reciprocating movement of the alignment member of the fourth conveyor alignment mechanism may be a back-and-forth linear motion between the fifth conveyor and the sixth conveyor.

The reciprocating movement may include a first stroke, in which the alignment member of the fourth conveyor alignment mechanism is moved in a first direction from the one of the fifth conveyor and the sixth conveyor towards the other of the fifth conveyor and the sixth conveyor and a second stroke, in which the alignment member of the fourth conveyor alignment mechanism is moved in an opposing second direction from the other of the fifth conveyor and the sixth conveyor back towards the one of the fifth conveyor and the sixth conveyor. The first stroke and the second stroke of the reciprocating movement of the alignment member of the fourth conveyor alignment mechanism may have a predetermined distance. The predetermined distance may be fixed.

The predetermined distance of the first stroke and the second stroke of the reciprocating movement of the alignment member of the fourth conveyor alignment mechanism may be the same as the predetermined distance of the first stroke and the second stroke of the reciprocating movement of the fourth conveyor alignment mechanism.

The alignment member of the fourth conveyor alignment mechanism may have a proximal end at which it is operably connected to the one of the fifth conveyor and the sixth conveyor and an opposing distal end. The reciprocating movement of the alignment member of the fourth conveyor alignment mechanism may be such that when the alignment member of the fourth conveyor alignment mechanism is moved relative to the one of the fifth conveyor and the sixth conveyor in a first direction (for example a direction of the first stroke), the distal end of the alignment member of the fourth conveyor alignment mechanism is moved closer to the other of the fifth conveyor and the sixth conveyor and when the alignment member of the fourth conveyor alignment mechanism is moved relative to the one of the fifth conveyor and the sixth conveyor in a second direction (for example a direction of the second stroke), the distal end of the alignment member of the fourth conveyor alignment mechanism moves away from the other of the fifth conveyor and the sixth conveyor.

The alignment member of the fourth conveyor alignment mechanism, for example the distal end of the alignment member of the fourth conveyor alignment mechanism, may be configured to move towards and engage the other of the fifth conveyor and the sixth conveyor when the exit door is in the open position.

The alignment member of the fourth conveyor alignment mechanism, for example the distal end of the alignment member of the fourth conveyor alignment mechanism, may be configured to retract (i.e. move away from) from the other of the fifth conveyor and the sixth conveyor when the exit door is moved from the open position to the closed position.

The alignment member of the fourth conveyor alignment mechanism may, in examples be an alignment pin or an alignment bar. The alignment member of the fourth conveyor alignment mechanism may include a telescopic member that reciprocates within a body of the fourth conveyor alignment mechanism.

The other of the fifth conveyor and the sixth conveyor may include an opening within which the alignment member of the fourth conveyor alignment mechanism is at least partially received when the fifth conveyor and the sixth conveyor are in the aligned configuration.

The opening may form part of a blind hole in the other of the fifth conveyor and the sixth conveyor. The blind hole may be configured to receive a part, for example the distal end, of the alignment member of the fourth conveyor alignment mechanism. The blind hole may have a predetermined length that is selected to control the distance that the alignment member of the fourth conveyor alignment mechanism can travel towards the other of the fifth conveyor and the sixth conveyor.

The fourth door opening mechanism may be configured to reciprocatingly move the exit door between the open position and the closed position in a second exit door opening plane, which second exit door opening plane is perpendicular to a fourth alignment member plane within which the alignment member of the fourth conveyor alignment mechanism reciprocates.

The fourth conveyor alignment mechanism may include a connector, for example a connector including a first end and an opposing second end, wherein the first end of the connector of the fourth conveyor alignment mechanism is operably coupled to the alignment member of the fourth conveyor alignment mechanism and the second end of the connector is operably coupled to the fourth door opening mechanism such that movement of the fourth door opening mechanism causes movement of the alignment member of the fourth conveyor alignment mechanism.

The alignment member of the fourth conveyor alignment mechanism may include an alignment member slot that is configured to receive the first end of the connector of the fourth conveyor alignment mechanism.

The fourth door opening mechanism may include a door opening mechanism slot that is configured to receive the second end of the connector of the fourth conveyor alignment mechanism.

The first end of the connector of the fourth conveyor alignment mechanism may be configured to move with the alignment member of the fourth conveyor alignment mechanism in the fourth alignment member plane and the second end of the connector may be configured to move with the fourth door opening mechanism in the second exit door opening plane.

The fourth door opening mechanism may include a channel, for example an enclosed channel. The channel may extend through at least a portion of the fourth door opening mechanism and may be configured to receive the alignment member of the fourth conveyor alignment mechanism. The alignment member of the fourth conveyor alignment mechanism may be configured to reciprocatingly move between the fifth conveyor and the sixth conveyor through the channel.

As described above in relation to the second door opening mechanism, the reflow soldering oven may include a further actuator. The further actuator may be configured to move the exit door between the open position and the closed position. In this way the fourth conveyor alignment mechanism may be moved to hold the fifth conveyor and the sixth conveyor in the aligned configuration when the exit door is in the open position and release the fifth conveyor and the sixth conveyor from the aligned configuration when the exit door moves from the open position to the closed position.

Within the scope of this application it is expressly intended that the various aspects, embodiments, examples and alternatives set out in the preceding paragraphs, in the claims and/or in the following description and drawings, and in particular the individual features thereof, may be taken independently or in any combination. That is, all embodiments and/or features of any embodiment can be combined in any way and/or combination, unless such features are incompatible. The applicant reserves the right to change any originally filed claim or file any new claim accordingly, including the right to amend any originally filed claim to depend from and/or incorporate any feature of any other claim although not originally claimed in that manner.

### BRIEF DESCRIPTION OF DRAWINGS

One or more embodiments of the invention will now be described, by way of example only, with reference to the accompanying drawings, in which:
FIG. 1 shows a schematic representation of a printed circuit board;
FIG. 2 shows a schematic representation of a reflow soldering oven;
FIG. 3 shows a schematic representation of another reflow soldering oven;
FIG. 4A shows a schematic representation of a reflow soldering oven in accordance with an embodiment of the present invention;
FIG. 4B shows an alternative schematic representation of the reflow soldering oven of FIG. 4A;
FIG. 5A shows a perspective view of part of a reflow soldering oven in accordance with an embodiment of the present invention;
FIG. 5B shows an alternative view of the reflow soldering oven of FIG. 5A;
FIG. 5C shows a schematic side view of the reflow soldering oven of FIG. 5A showing a conveyor alignment mechanism and a door opening mechanism;
FIG. 5D shows the conveyor alignment mechanism of FIG. 5C in a retracted configuration; and
FIG. 5E shows the conveyor alignment mechanism of FIG. 5C in an aligned configuration.

### DETAILED DESCRIPTION

Certain terminology is used in the following description for convenience only and is not limiting. The words 'right', 'left', 'lower', 'upper', 'front', 'rear', 'upward', 'down' and 'downward' designate directions in the drawings to which reference is made and are with respect to the described component when assembled and mounted. The words 'inner', 'inwardly', 'outer' and 'outwardly' refer to directions toward and away from, respectively, a designated centreline or a geometric centre of an element being described (e.g. central axis), the particular meaning being readily apparent from the context of the description.

Further, as used herein, the terms 'connected', 'attached', 'coupled' and 'mounted' are intended to include direct connections between two members without any other members interposed therebetween, as well as, indirect connections between members in which one or more other members are interposed therebetween. The terminology includes the words specifically mentioned above, derivatives thereof, and words of similar import.

Further, unless otherwise specified, the use of ordinal adjectives, such as, "first", "second" and "third" etc. merely indicate that different instances of like objects are being referred to and are not intended to imply that the objects so described must be in a given sequence, either temporally, spatially, in ranking or in any other manner.

Like reference numerals are used to depict like features throughout the specification.

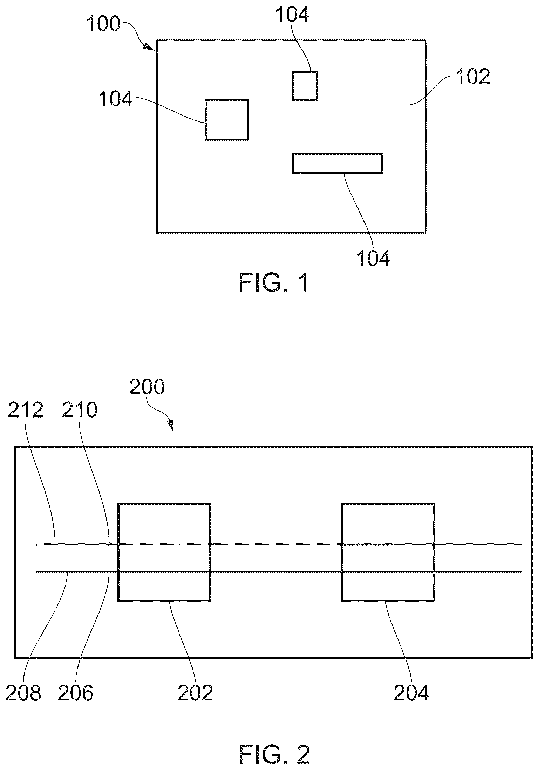

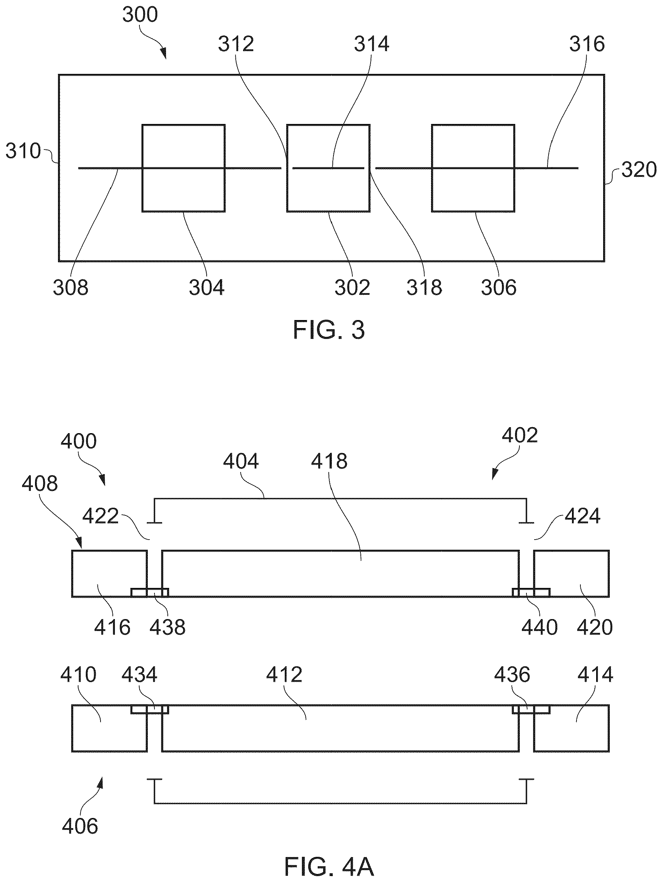

An example of a printed circuit board will be described with reference to FIG. 1. Examples of known reflow soldering ovens will be described with reference to FIG. 2 and FIG. 3.

Reflow soldering ovens including a vacuum chamber and vacuum systems in accordance with embodiments of the present invention will be described with reference to FIG. 4A to FIG. 5E.

Typical reflow soldering processes for the manufacture of printed circuit boards will be described with particular reference to FIG. 1, FIG. 2 and FIG. 3.

As shown in FIG. 1, a printed circuit board 100 includes a substrate 102 or wafer on which a number of electronic elements 104 are mounted.

The electronic elements 104 are mounted on the printed circuit board 100 using solder paste (e.g. tin paste). A wire of each electronic element 104 is deposited on the required area of the printed circuit board 100 and inserted into the deposited solder paste (not shown).

The printed circuit board 100 is then passed through a reflow soldering oven 200, 300 as will be described with reference to FIG. 2 and FIG. 3.

Referring now to FIG. 2, the reflow soldering oven 200 has a heating area 202 and a cooling area 204. The reflow soldering oven 200 also has two conveyor paths: a first conveyor 206 forming the first conveyor path 208 and a second conveyor 210 forming the second conveyor path 212.

In known reflow soldering processes, printed circuit boards 100 are transferred through the components of the reflow soldering oven 200, including the heating area 202 and the cooling area 204, on one of the first conveyor 206 and the second conveyor 210.

In the heating area 202, the soldering paste refluxes (i.e. is heated to a melting or reflux temperature).

Once transferred to the cooling area 204, the soldering paste is cooled to form solder joints that electrically and mechanically connect the wires of the electronic elements 104 to the printed circuit board 100.

The provision of two (or more) parallel conveyor paths enables the number of printed circuit boards 100 that are manufactured to be increased. It will be appreciated that the reflow soldering oven 200 may have one, two or any number of conveyor paths.

During the reflow soldering process, air or gas filled spaces, called voids, can be formed in the solder, for example in the bulk of the solder or at the intermetallic boundaries of the solder joint. Such voids may be caused by trapped flux gases or inadequate wetting of the solder. Larger voids may lead to mechanical weakness, electrical resistance, poor heat dissipation and reliability issues. In high-power electronics, such issues may ultimately result in component failure.

To prevent, or at least significantly reduce voids in solder joints, it is known to provide reflow soldering ovens reflow soldering oven 300 that have integrated vacuum chambers 302, which may be referred to as reflow soldering vacuum chambers.

Like the reflow soldering oven 200, the reflow soldering oven 300 includes a heating area 304 and a cooling area 306.

In the heating area 304, the temperature of the solder is increased to its liquidus temperature. The printed circuit boards 100 are then conveyed to the vacuum chamber 302, where the reduced pressure facilitates the removal of volatile gases in the solder.

Next, the printed circuit boards 100 are transferred to the cooling area 306, where the soldering paste is cooled to form solder joints that electrically and mechanically connect the wires of the electronic elements 104 to the printed circuit board 100.

The printed circuit boards 100 are transferred through the components of the reflow soldering oven 300, including the heating area 304, the vacuum chamber 302 and the cooling area 306 using conveyors 308, 314, 316.

The vacuum chamber 302 needs to be completely sealed to generate a low pressure and so it is not possible to use a single conveyor that extends through each of the heating area 304, the vacuum chamber 302 and the cooling area 306. It is, therefore, necessary to 'split' the conveyor.

As such, a first conveyor 308 may be provided from the entrance 310 of the reflow soldering oven 300, through the heating area 304 to the vacuum chamber 302.

Printed circuit boards 100 are then transferred through an entrance door 312 of the vacuum chamber to a second conveyor 314 that is positioned within the vacuum chamber 302.

Finally, the printed circuit boards 100 are transferred to a third conveyor 316 that is provided adjacent to an exit door 318 of the vacuum chamber 302. The third conveyor 316 conveys the printed circuit boards 100 from the exit door 318 of the reflow soldering oven 300, through the cooling area 306 and to the exit 320 of the reflow soldering oven 300.

The speed of the conveyors 308, 314, 316 is relatively high in order to maximise the efficiency of the reflow soldering process and to ensure that the time the solder is above its liquidus temperature does not exceed the requirements of the solder material (typically less than 90 seconds). Due to the different temperatures in different components of the reflow soldering oven 300 and the different properties (e.g. extension and/or thermal coefficients) of the materials used to manufacture the different components of the reflow soldering oven, ensuring that the conveyors 308, 314, 316 are correctly aligned (and retained in the aligned position) is challenging.

Misalignment of the conveyors can result in printed circuit boards getting stuck or jammed between conveyors. Vibration of the printed circuit boards may also cause electronic elements to fall off or be displaced on the circuit boards. This can result in machine downtime and the need to scrap affected circuit boards.

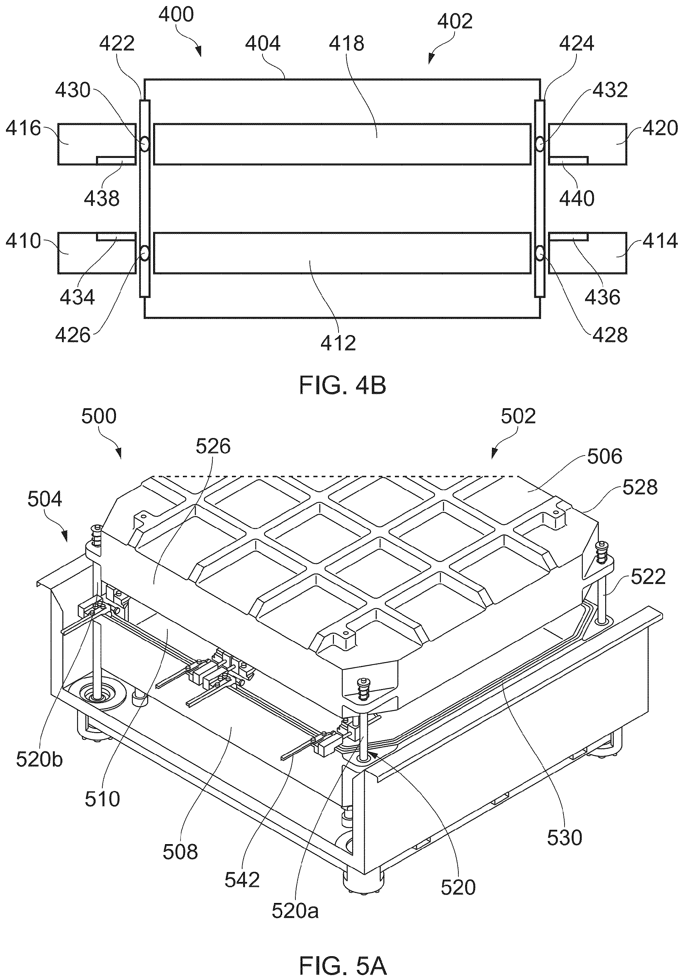

A reflow soldering oven 400 including a vacuum system 402 according to an embodiment of the invention will be described with particular reference to FIG. 4A and FIG. 4B.

The reflow soldering oven 400 includes a vacuum system 402 that has a vacuum chamber 404 and a vacuum pump (not shown).

The reflow soldering oven 400 includes a first conveyor path 406 and a second conveyor path 408.

The first conveyor path 406 includes a first conveyor 410, a second conveyor 412 and a third conveyor 414.

The second conveyor path 408 includes a fourth conveyor 416, a fifth conveyor 418 and a sixth conveyor 420.

The first conveyor path 406 is parallel to the second conveyor path 408.

The vacuum chamber includes an entrance door 422 and an exit door 424. As shown in FIG. 4A, each of the entrance door 422 and the exit door 424 is in an open position.

FIG. 4B shows each of the entrance door 422 and the exit door 424 in a closed position. As also shown in FIG. 4B, the vacuum chamber 404 includes a first door opening mechanism 426, a second door opening mechanism 428, a third door opening mechanism 430 and a fourth door opening mechanism 432.

The first door opening mechanism 426 and the third door opening mechanism are associated with the entrance door 422 of the vacuum chamber 404.

The second door opening mechanism 428 and the fourth door opening mechanism 432 are associated with the exit door 424 of the vacuum chamber 404.

Referring again to FIG. 4A, the reflow soldering oven 400 includes a first conveyor alignment mechanism 434, a second conveyor alignment mechanism 436, a third conveyor alignment mechanism 438 and a fourth conveyor alignment mechanism 440.

The first conveyor alignment mechanism 434 is associated with the first conveyor 410 and the second conveyor 412. The first conveyor alignment mechanism 434 is operably connected to the first door opening mechanism 426.

The second conveyor alignment mechanism 436 is associated with the second conveyor 412 and the third conveyor 414. The second conveyor alignment mechanism 436 is operably connected to the second door opening mechanism 428.

The third conveyor alignment mechanism 438 is associated with the fourth conveyor 416 and the fifth conveyor 418. The third conveyor alignment mechanism 438 is operably connected to the third door opening mechanism 430.

The fourth conveyor alignment mechanism 440 is associated with the fifth conveyor 418 and the sixth conveyor 420. The fourth conveyor alignment mechanism 440 is operably connected to the fourth door opening mechanism 432.

As shown in FIG. 4A, when the entrance door 422 of the vacuum chamber 404 is in the open position, the first conveyor alignment mechanism 434 is operably connected to each of the first conveyor 410 and the second conveyor 412. In this way, the first conveyor 410 and the second conveyor 412 are held in an aligned configuration when the entrance door 422 is in the open position.

In the same way, when the entrance door 422 of the vacuum chamber 404 is in the open position, the third conveyor alignment mechanism 438 is operably connected to each of the fourth conveyor 416 and the fifth conveyor 418 such that the fourth conveyor 416 and the fifth conveyor 418 are held in an aligned configuration when the entrance door 422 is in the open position.

As also shown in FIG. 4A, when the exit door 424 of the vacuum chamber 404 is in the open position, the second conveyor alignment mechanism 436 is operably connected to each of the second conveyor 412 and the third conveyor 414 such that the second conveyor 412 and the third conveyor 414 are held in an aligned configuration when the exit door 424 is in the open position.

In the same way, when the exit door 424 of the vacuum chamber 404 is in the open position, the fourth conveyor alignment mechanism 440 is operably connected to each of the fifth conveyor 418 and the sixth conveyor 420 such that the fifth conveyor 418 and the sixth conveyor 420 are held in an aligned configuration when the exit door 424 is in the open position.

Referring again to FIG. 4B, when the entrance door 422 of the vacuum chamber 404 is in the closed position, the first conveyor alignment mechanism 434 is retracted from the second conveyor 412 and the first conveyor 410 and the second conveyor 412 are no longer held in the aligned configuration. The first door opening mechanism 426 is operably connected to the first conveyor alignment mechanism 434 to effect the retraction of the first conveyor alignment mechanism 434 from the second conveyor 412 in order to release the first conveyor 410 and the second conveyor 412 from the aligned configuration when the first door opening mechanism 426 moves the entrance door 422 from the open position to the closed position.

When the entrance door 422 is in the closed position, the third conveyor alignment mechanism 438 is retracted from the fifth conveyor 418 and the fourth conveyor 416 and the fifth conveyor 418 are no longer held in the aligned configuration. The third door opening mechanism 430 is operably connected to the third conveyor alignment mechanism 438 to effect the retraction of the third conveyor alignment mechanism 438 from the fifth conveyor 418 in order to release the fourth conveyor 416 and the fifth conveyor 418 from the aligned configuration when the third door opening mechanism 430 moves the entrance door 422 from the open position to the closed position.

In other words, when the entrance door 422 is in the closed position, each of the first conveyor alignment mechanism 434 and the third conveyor alignment mechanism 438 is in a retracted configuration.

In the same way, when the exit door 424 of the vacuum chamber 404 is in the closed position, the second conveyor alignment mechanism 436 is retracted from the second conveyor 412 and the second conveyor 412 and the third conveyor 414 are no longer held in the aligned configuration. The second door opening mechanism 428 is operably connected to the second conveyor alignment mechanism 436 to effect the retraction of the second conveyor alignment mechanism 436 from the second conveyor 412 in order to release the second conveyor 412 and the third conveyor 414 from the aligned configuration when the second door opening mechanism 428 moves the exit door 424 from the open position to the closed position.

When the exit door 424 is in the closed position, the fourth conveyor alignment mechanism 440 is retracted from the fifth conveyor 418 and the fifth conveyor 418 and the sixth conveyor 420 are no longer held in the aligned configuration. The fourth door opening mechanism 432 is operably connected to the fourth conveyor alignment mechanism 440 to effect the retraction of the fourth conveyor alignment mechanism 440 from the fifth conveyor 418 in order to release the fifth conveyor 418 and the sixth conveyor 420 from the aligned configuration when the fourth conveyor alignment mechanism 440 moves the exit door 424 from the open position to the closed position.

In other words, when the exit door 424 is in the closed position, each of the second conveyor alignment mechanism 436 and the fourth conveyor alignment mechanism 440 is in a retracted configuration.

As shown in FIG. 4A, each of the entrance door 422 and the exit door 424 is in the open position. Similarly, as shown in FIG. 4B, each of the entrance door 422 and the exit door 424 is in the closed position. It will be appreciated that, at times during operation of the reflow soldering oven 400, the entrance door 422 may be in the closed position when the exit door 424 is in the open position and that, at other times during operation of the reflow soldering oven 400, the entrance door 422 may be in the open position when the exit door 424 is in the closed position. Each of the first conveyor alignment mechanism 434, the second conveyor alignment mechanism 436, the third conveyor alignment mechanism 438 and the fourth conveyor alignment mechanism 440 may thus be operated independently of the other conveyor alignment mechanisms.

As shown and described with reference to FIG. 4A and FIG. 4B, the first conveyor alignment mechanism 434 is operably connected to the first conveyor 410 when the entrance door 422 is in the closed position and is operably connected to each of the first conveyor 410 and the second conveyor 412 when the entrance door 422 is in the open position.

It will be appreciated that, in embodiments of the invention, the first conveyor alignment mechanism 434 may be operably connected to the second conveyor 412 when the entrance door 422 is in the closed position and may be operably connected to each of the first conveyor 410 and the second conveyor 412 when the entrance door 422 is in the open position.

In other words, the first conveyor alignment mechanism 434 may be operably connected to either one of the first conveyor 410 and the second conveyor 412 when the entrance door 422 is in the closed position and the first conveyor alignment mechanism 434 may be operably connected to each of the first conveyor 410 and the second conveyor 412 when the entrance door 422 is in the open position.

As shown and described with reference to FIG. 4A and FIG. 4B, the second conveyor alignment mechanism 436 is operably connected to the third conveyor 414 when the exit door 424 is in the closed position and is operably connected to each of the second conveyor 412 and the third conveyor 414 when the exit door 424 is in the open position.

It will be appreciated that, in embodiments of the invention, the second conveyor alignment mechanism 436 may be operably connected to the second conveyor 412 when the exit door 424 is in the closed position and may be operably connected to each of the second conveyor 412 and the third conveyor 414 when the exit door 424 is in the open position.

In other words, the second conveyor alignment mechanism 436 may be operably connected to either one of the second conveyor 412 and the third conveyor 414 when the exit door 424 is in the closed position and the second conveyor alignment mechanism 436 may be operably connected to each of the second conveyor 412 and the third conveyor 414 when the exit door 424 is in the open position.

Similarly, as described above, the third conveyor alignment mechanism 438 is operably connected to the fourth conveyor 416 when the entrance door 422 is in the closed position and is operably connected to each of the fourth conveyor 416 and the fifth conveyor 418 when the entrance door 422 is in the open position.

It will be appreciated that, in embodiments of the invention, the third conveyor alignment mechanism 438 may be operably connected to the fifth conveyor 418 when the entrance door 422 is in the closed position and may be operably connected to each of the fourth conveyor 416 and the fifth conveyor 418 when the entrance door 422 is in the open position.

In other words, the third conveyor alignment mechanism 438 may be operably connected to either one of the fourth conveyor 416 and the fifth conveyor 418 when the entrance door 422 is in the closed position and the third conveyor alignment mechanism 438 may be operably connected to each of the fourth conveyor 416 and the fifth conveyor 418 when the entrance door 422 is in the open position.

As also described above, fourth conveyor alignment mechanism 440 is operably connected to the sixth conveyor 420 when the exit door 424 is in the closed position and is operably connected to each of the fifth conveyor 418 and the sixth conveyor 420 when the exit door 424 is in the open position.

It will be appreciated that, in embodiments of the invention, the fourth conveyor alignment mechanism 440 may be operably connected to the fifth conveyor 418 when the exit door 424 is in the closed position and may be operably connected to each of the fifth conveyor 418 and the sixth conveyor 420 when the exit door 424 is in the open position.

In other words, the fourth conveyor alignment mechanism 440 may be operably connected to either one of the fifth conveyor 418 and the sixth conveyor 420 when the exit door 424 is in the closed position and the fourth conveyor alignment mechanism 440 may be operably connected to each of the fifth conveyor 418 and the sixth conveyor 420 when the exit door 424 is in the open position.

A reflow soldering oven 500 according to another embodiment of the invention will now be described with particular reference to FIG. 5A to FIG. 5E.

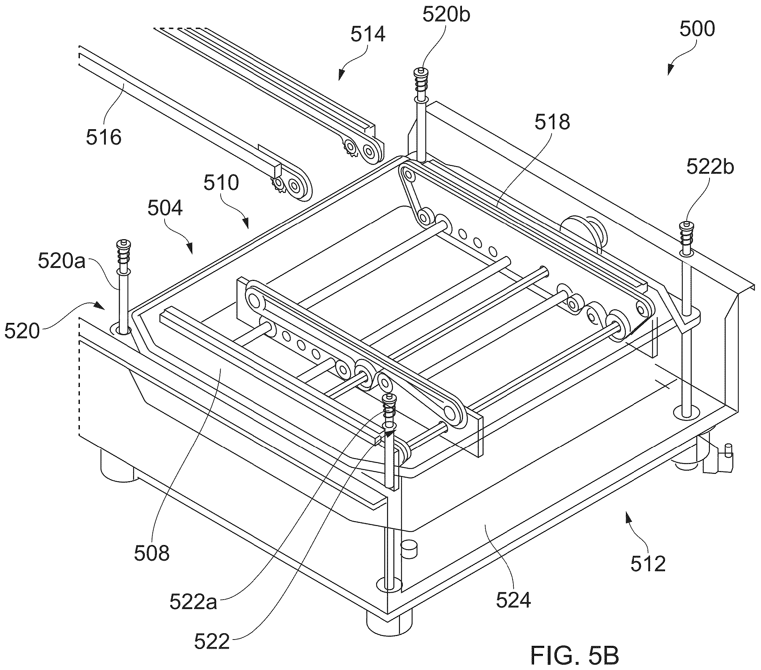

As shown in FIG. 5A and FIG. 5B, the reflow soldering oven 500 includes a vacuum system 502 including a vacuum chamber 504. The vacuum chamber 504 includes an upper chamber portion 506, e.g. an upper chamber box or lid, and a lower chamber portion 508, e.g. a lower chamber box or body. The vacuum chamber 504 includes an entrance 510 (at which items e.g. printed circuit boards are conveyed into the vacuum chamber 504) and an exit 512 (at which items, e.g. printed circuit boards are conveyed out of the vacuum chamber 504).

With particular reference to FIG. 5B, a single conveyor path 514 is provided through this part of the reflow soldering oven 500 from the entrance 510, through the vacuum chamber 504 to the exit 512. The conveyor path 514 includes a first conveyor 516 and a second conveyor 518.

The first conveyor 516 is positioned outside the vacuum chamber 504 adjacent to the entrance 510. The second conveyor 518 is position within the vacuum chamber 504 between the entrance 510 and the exit 512.

The vacuum chamber 504 also includes a first door opening mechanism 520 that is positioned adjacent to the entrance 510 and a second door opening mechanism 522 that is positioned adjacent to the exit 512.

The first door opening mechanism 520 includes a pair of shafts 520a, 520b, which extend upwardly from a base 524 of the vacuum chamber 504.

Similarly, the second door opening mechanism 522 includes a pair of shafts 522a, 522b, which extend upwardly from the base 524 of the vacuum chamber 504.

The door opening mechanisms 520, 522 are operated to reciprocally move the upper chamber portion 506 relative to the lower chamber portion 508 between an open position and a closed position. The first door opening mechanism 520 and the second door opening mechanism 522 are operated to move the upper chamber portion 506 in a first direction, e.g. an upward direction, away from the lower chamber portion 508 to open the vacuum chamber 504 and in an opposing second direction, e.g. a downward direction, towards the lower chamber portion 508 in order to close the vacuum chamber 504.

Referring again to FIG. 5A, a part of the wall of the upper chamber portion 506 that is located adjacent to the entrance 510 may be considered to be an entrance door 526 of the vacuum chamber 504 since, when the upper chamber portion 506 is moved, e.g. raised, away from the lower chamber portion 508, the entrance 510 is opened such that the entrance door 526 is in an open position.

Similarly, another part of the wall of the upper chamber portion 506 that is located adjacent to the exit 512 may be considered to be an exit door 528 since, when the upper chamber portion 506 is moved or raised away from the lower chamber portion 508, the exit 512 is opened such that the exit door 528 is in an open position.

Conversely, when the upper chamber portion 506 is moved, e.g. lowered, toward the lower chamber portion 508, the entrance 510 and the exit 512 are closed and the entrance door 526 and the exit door 528 may be considered to be in a closed position.

A seal 530 extends around a periphery of the lower chamber portion 508 in order to ensure that when the upper chamber portion 506 is lowered toward and engages the lower chamber portion 508, and the entrance door 526 is in the closed position, the vacuum chamber 504 is sealed.

As can be seen in FIG. 5B, the first conveyor 516 is positioned close enough to the entrance 510 of the vacuum chamber 504 that when the entrance door 526 is open, an item, for example a printed circuit board 100 can be transferred from the first conveyor 516 to the second conveyor 518.

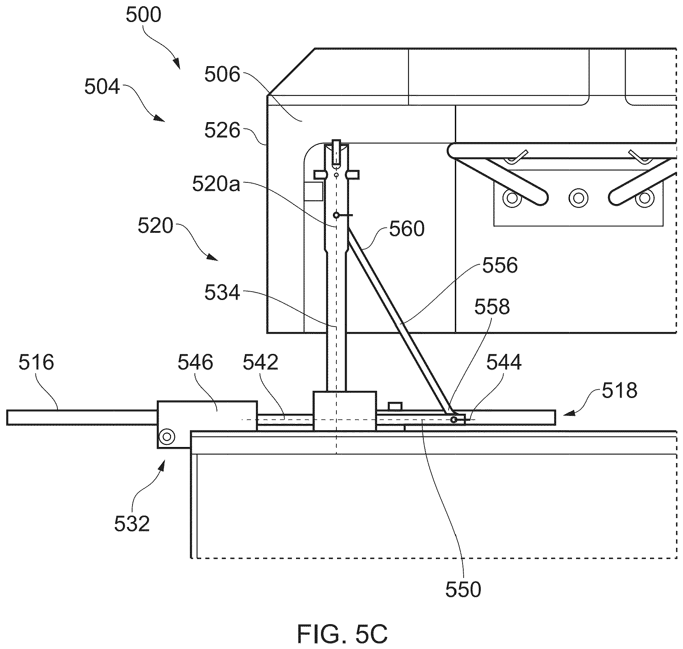

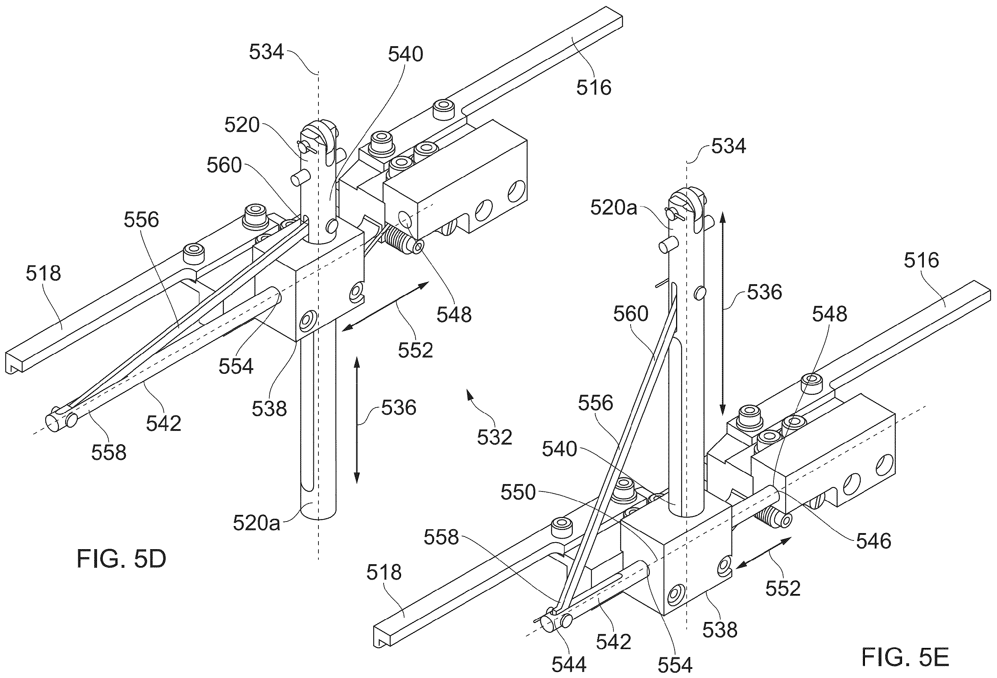

As will be described with reference to FIG. 5C, FIG. 5D and FIG. 5E, the reflow soldering oven 500 includes a conveyor alignment mechanism 532 that ensures that the first conveyor 516 and the second conveyor 518 are correctly aligned and secured in the aligned configuration when the entrance door 526 is in the open position. In this way, the present invention ensures that the transfer of the item, e.g. a printed circuit board 100 from the first conveyor 516 to the second conveyor 518 is both accurate and efficient.

As will also be described in more detail, the conveyor alignment mechanism 532 is operably connected to the first door opening mechanism 520 to ensure that, when it is necessary to move the entrance door 526 to the closed position (to ensure that the desired pressure in the vacuum chamber 504 can be achieved), the conveyor alignment mechanism 532 is retracted and does not interfere with the correct operation of any part of the vacuum chamber 504, including (but not limited to) the upper chamber portion 506 and the entrance door 526.

As described above, the first door opening mechanism 520 includes a shaft 520a. The shaft 520a has a longitudinal axis 534. The longitudinal axis 534 of the shaft 520a extends in a direction which is parallel to a plane in which the upper chamber portion 506 moves away from and towards the lower chamber portion 508 in order to open and close the entrance door 526 and the exit door 528 (i.e. the door opening plane 536). The first door opening mechanism 520 has a body 538 which includes a shaft channel 540 within which the shaft 520a is slidingly received and reciprocatingly moves.

With particular reference to FIG. 5C, the conveyor alignment mechanism 532 includes an alignment member 542 that has a first end 544 and an opposing second end 546. The second end 546 of the alignment member 542 is operably connected to the second conveyor 518. The alignment member 542 is configured such that it can be moved, for example slidingly moved, between an extended position in which the first end 544 of the alignment member 542 is received within an opening 548 of the first conveyor 516 (as shown in FIG. 5C and FIG. 5E) and a retracted position in which the first end 544 of the alignment member 542 is retracted away from the opening 548 of the first conveyor 516. The alignment member 542 has a longitudinal axis 550 that extends in a direction which is parallel to a plane in which the alignment member 542 reciprocatingly moves toward and away from the opening of the first conveyor 516 (i.e. the alignment member plane 552).

The body 538 of the first door opening mechanism 520 includes an alignment member channel 554 within which the alignment member 542 is slidingly received and reciprocatingly moves.

The longitudinal axis 534 of the shaft 520a is perpendicular to the longitudinal axis 550 of the alignment member 542.

In the same way, the shaft channel 540 extends in a direction that is perpendicular to the alignment member channel 554 and the door opening plane 536 is perpendicular to the alignment member plane 552 (such that the directions in which the shaft 520a reciprocatingly moves are perpendicular to the directions in which the alignment member 542 reciprocatingly moves).

The conveyor alignment mechanism 532 also includes a connector 556. The connector 556 has a first end 558 and an opposing second end 560.

The first end 558 of the connector 556 is operably connected to the first end 544 of the alignment member 542. The opposing second end 560 of the connector 556 is operably connected to the shaft 520a of the first door opening mechanism 520. In this way, the alignment member 542 is operably connected to the first door opening mechanism 520 such that movement of the shaft 520a of the first door opening mechanism 520 in the door opening plane 536 results in movement of the alignment member 542 of the conveyor alignment mechanism 532 in the alignment member plane 552, which alignment member plane 552 is perpendicular to the door opening plane 536. The connector 556 thus enables the conveyor alignment mechanism 532 to be operably coupled to the first door opening mechanism 520.

The shaft 520a, the alignment member 542 and the connector 556 may thus form a Scott Russell linkage, which converts the vertical motion of the entrance door 526 by a first door opening mechanism 520 into horizontal movement of the alignment member 542 of the conveyor alignment mechanism 532.

Operation of the door opening mechanisms and the conveyor alignment mechanisms of the reflow soldering oven 500 will now be described with particular reference to FIG. 5D and FIG. 5E.

Referring now to FIG. 5D, the arrangement of the first door opening mechanism 520 and the conveyor alignment mechanism 532 when the entrance door 526 of the vacuum chamber 504 is in the closed position is shown.

When the entrance door 526 is in the closed position, the alignment member 542 is retracted away from the first conveyor 516.

The shaft 520a is lowered through the shaft channel 540 of the body 538 such that the upper chamber portion 506 is sealingly engaged with the lower chamber portion 508. In this arrangement, the entrance door 526 is positioned between the first conveyor 516 and the second conveyor 518.

The opposing second end 560 of the connector 556 is lowered toward the body 538 of the first door opening mechanism 520 in the door opening plane 536 and the first end 558 of the connector 556, which is operably connected to the first end 544 of the alignment member 542 moves away from the body 538 and away from the first conveyor 516 in the alignment member plane 552 such that the opposing second end 546 of the alignment member 542 is moved away from the opening 548 of the first conveyor 516.

In other words, the vertical motion of the entrance door 526, in particular vertical motion effected by the shaft 520a of the first door opening mechanism 520, is converted into the horizontal movement of the alignment member 542 of the conveyor alignment mechanism 532 via the connector 556 which is connected to each of the shaft 520a of the first door opening mechanism 520 and the alignment member 542 of the conveyor alignment mechanism 532.

In this, retracted configuration, there is no direct mechanical connection between the first conveyor 516 and the second conveyor 518 and thus an item, for example a printed circuit board 100 may not be transferred from the first conveyor 516 on the outside of the vacuum chamber 504 to the second conveyor 518 within the vacuum chamber 504.

In other words, the upper chamber portion 506 may be sealingly engaged with the lower chamber portion 508 and no part of the conveyor path 514 interferes with operation of the entrance door 526 of the vacuum chamber 504.

Once sealed, the required low-pressure conditions can be achieved in the vacuum chamber 504, aiding in the removal of gases from the liquid solder. This results in fewer voids and stronger, more reliable solder joints being formed between electronic elements 104 and the substrate 102 of the printed circuit boards 100.

Once the removal of voids in the solder of items, e.g. printed circuit boards 100, within the vacuum chamber 504 has been achieved, the upper chamber portion 506 may be lifted away from the lower chamber portion 508 such that the exit door 528 is opened, and the items may be transferred from the second conveyor 518 to the third conveyor (not shown).

At the same time, in order to ensure efficiency of the reflow soldering process, the entrance door 526 is opened so that a new item, e.g. a printed circuit board 100, can be conveyed from the first conveyor 516 to the second conveyor 518 to ensure that voids are removed from the solder paste between the electronic elements 104 and the substrate 102 of that printed circuit board 100.

In order to ensure that items, e.g. the printed circuit boards 100, are conveyed efficiency between the first conveyor 516 and the second conveyor 518, it is important to ensure that the first conveyor 516 and the second conveyor 518 are correctly aligned and held in that aligned configuration when the entrance door 526 is in the open position.

To achieve this, the first door opening mechanism 520 and the conveyor alignment mechanism 532 are operated as follows, with reference to FIG. 5E.

The shaft 520a is moved in the door opening plane 536 such that the upper chamber portion 506 is moved away from the lower chamber portion 508 of the vacuum chamber 504.

This causes the opposing second end 560 of the connector 556 to be moved away from the body 538 of the first door opening mechanism 520 and the first end 558 of the connector 556 and the first end 544 of the alignment member 542 to be moved toward the body 538 such that the opposing second end 546 of the alignment member 542 is moved toward the opening 548 of the first conveyor 516. When the first conveyor 516 and the second conveyor 518 are correctly aligned, i.e. in the aligned configuration, the opposing second end 546 of the alignment member 542 is received in the opening 548 of the first conveyor 516 such that the first conveyor 516 and the second conveyor 518 are held in the aligned configuration.

When the entrance door 526 is in the open position, the first conveyor 516 and the second conveyor 518 are correctly aligned (and held in that position) in order to ensure the accurate, smooth and efficient transfer of items, e.g. printed circuit boards 100 between the first conveyor 516 and the second conveyor 518. The alignment member 542 thus precisely centers and aligns the first conveyor 516 and the second conveyor 518, eliminating any misalignment that could occur due to thermal expansion or other mechanical stresses during operation.

The shaft channel 540 and the alignment member channel 554 are particularly advantageous as they enable the accurate, smooth and efficient transfer of items, e.g. printed circuit boards 100, between conveyors whilst ensuring that the first door opening mechanism 520 and the conveyor alignment mechanism 532 are as compact as possible.

It will be appreciated by persons skilled in the art that the above detailed examples have been described by way of example only and not in any limitative sense, and that various alterations and modifications are possible without departing from the scope of the invention as defined by the appended claims. Various modifications to the detailed examples described above are possible.

Through the description and claims of this specification, the words "comprise" and "contain" and variations of them mean "including but not limited to", and they are not intended to (and do not) exclude other moieties, additives, components, integers or steps. Throughout the description and claims of this specification, the singular encompasses the plural unless the context otherwise requires. In particular, where the indefinite article is used, the specification is to be understood as contemplating plurality as well as singularity, unless the context requires otherwise.

Features, integers, characteristics, compounds, chemical moieties or groups described in conjunction with a particular aspect, embodiment or example of the invention are to be understood to be applicable to any other aspect, embodiment or example described herein unless incompatible therewith. All of the features disclosed in this specification (including any accompanying claims, abstract and drawings), and/or all of the steps of any method or process so disclosed, may be combined in any combination, except combinations where at least some of such features and/or steps are mutually exclusive. The invention is not restricted to the details of any foregoing embodiments. The invention extends to any novel one, or any novel combination, of the features disclosed in this specification (including any accompanying claims, abstract or drawings), or to any novel one, or any novel combination, of the steps of any method or process so disclosed.

Certain embodiments of the invention are described in the following clauses:
Clause 1. A reflow soldering oven comprising:
   a vacuum chamber comprising a door;
   a first conveyor that is positioned outside of the vacuum chamber; and
   a second conveyor that is positioned inside the vacuum chamber;
   wherein the door comprises a door opening mechanism that is configured to move the door between an open position, in which an item may be conveyed between the first conveyor and the second conveyor, and a closed position, in which the first conveyor and the second conveyor are separated by the door; and
   wherein the reflow soldering oven comprises a conveyor alignment mechanism that is operably connected to the door opening mechanism and is configured to hold the first conveyor and the second conveyor in an aligned configuration when the door is in the open position.
Clause 2. The reflow soldering oven of clause 1, wherein the conveyor alignment mechanism is configured to release the first conveyor and the second conveyor from the aligned configuration when the door is moved from the open position to the closed position.
Clause 3. The reflow soldering oven of clause 1 or clause 2, wherein the conveyor alignment mechanism is configured to reciprocatingly move between the first conveyor and the second conveyor.
Clause 4. The reflow soldering oven of clause 3, wherein the conveyor alignment mechanism comprises an alignment member that is operably coupled to one of the first conveyor and the second conveyor, and wherein the alignment member is configured to reciprocatingly move between the first conveyor and the second conveyor.
Clause 5. The reflow soldering oven of clause 4, wherein the alignment member is configured to move towards and engage the other of the first conveyor and the second conveyor when the door is in the open position.
Clause 6. The reflow soldering oven of clause 4 or clause 5, wherein the alignment member is configured to retract from the other of the first conveyor and the second conveyor when the door is moved from the open position to the closed position.
Clause 7. The reflow soldering oven of any one of clauses 4 to 6, wherein the other of the first conveyor and the second conveyor includes an opening within which the alignment member is at least partially received when the first conveyor and the second conveyor are in the aligned configuration.
Clause 8. The reflow soldering oven of clause 7, wherein the opening forms part of a blind hole in the other of the first conveyor and the second conveyor.
Clause 9. The reflow soldering oven of any one of clauses 3 to 8, wherein the door opening mechanism is configured to reciprocatingly move the door between the open position and the closed position in a door opening plane, which door opening plane is perpendicular to an alignment member plane in which the alignment member reciprocates.
Clause 10. The reflow soldering oven of any one of clauses 3 to 9, wherein the conveyor alignment mechanism comprises a connector and the connector comprises a first end and an opposing second end, wherein the first end of the connector is operably coupled to the alignment member and the second end of the connector is operably coupled to the door opening mechanism such that movement of the door opening mechanism causes movement of the alignment member.
Clause 11. The reflow soldering oven of clause 10, wherein the first end of the connector moves with the alignment member in the alignment member plane and the second end of the connector moves with the door opening mechanism in the door opening plane.
Clause 12. The reflow soldering oven of any one of clauses 3 to 11, wherein the door opening mechanism comprises a channel, wherein the channel extends through at least a portion of the door opening mechanism and is configured to receive the alignment member, and wherein the alignment member is configured to reciprocatingly move between the first conveyor and the second conveyor through the channel.
Clause 13. The reflow soldering oven of any one of clauses 1 to 12, comprising an actuator, wherein the actuator is configured to move the door between the open position and the closed position and therefore move the conveyor alignment mechanism to hold the first conveyor and the second conveyor in the aligned configuration when the door is in the open position and release the first conveyor and the second conveyor from the aligned configuration when the door moves from the open position to the closed position.
Clause 14. The reflow soldering oven of any one of clauses 1 to 13,
   wherein the door is an entrance door and the vacuum chamber comprises an exit door;
   wherein the first conveyor is an entrance conveyor and is positioned outside of the vacuum chamber adjacent the entrance door; and
   the reflow soldering oven comprises a third exit conveyor that is positioned outside of the vacuum chamber adjacent the exit door;
   wherein the door opening mechanism is a first door opening mechanism and the reflow soldering oven comprises a second door opening mechanism,
   wherein the second door opening mechanism is configured to move the exit door between an open position, in which an item may be conveyed between the second conveyor and the third conveyor, and a closed position, in which the second conveyor and the third conveyor are separated by the exit door; and
   wherein the conveyor alignment mechanism is a first conveyor alignment mechanism and the reflow soldering oven comprises a second conveyor alignment mechanism that is operably connected to the second door opening mechanism and is configured to hold the second conveyor and the third conveyor in an aligned configuration when the exit door is in the open position.
Clause 15. A reflow soldering oven comprising:
   a vacuum chamber;
   a first conveyor that is positioned outside of the vacuum chamber; and
   a second conveyor that is positioned inside the vacuum chamber;
   wherein the first conveyor comprises a first conveyor side rail having a longitudinal axis, and the
   second conveyor comprises a second conveyor side rail having a longitudinal axis; and
   wherein the reflow soldering oven comprises:
      a conveyor alignment mechanism comprising an alignment member; wherein the alignment member is movably coupled to one of the first conveyor side rail and the second conveyor side rail, and the conveyor alignment mechanism is configured to move the alignment member between:
      a first position in which the alignment member is spaced apart from the other of the first conveyor side rail and the second conveyor, and
      a second position in which the alignment member engages the other of the first conveyor side rail and the second conveyor side rail such that the first conveyor and the second conveyor are held in an aligned configuration in which the longitudinal axis of the first conveyor side rail is aligned with the longitudinal axis of the second conveyor side rail.
Clause 16. The reflow soldering oven of clause 15, wherein the other of the first conveyor and the second conveyor includes an opening within which the alignment member is at least partially received when the first conveyor and the second conveyor are in the aligned configuration.
Clause 17. The reflow soldering oven of clause 16, wherein the opening is provided in the side rail of the other of the first conveyor and the second conveyor.
Clause 18. The reflow soldering oven of clause 16 or clause 17, wherein the opening forms part of a blind hole in the other of the first conveyor and the second conveyor.
Clause 19. The reflow soldering oven of any one of clauses 15 to 18, wherein the vacuum chamber comprises a door and the reflow soldering oven comprises a door opening mechanism
   that is configured to move the door between:
   an open position, in which an item may be conveyed between the first conveyor and the second conveyor, and
   a closed position, in which the first conveyor and the second conveyor are separated by the door; and
   wherein the conveyor alignment mechanism is operably connected to the door opening mechanism such that when the door is moved from the closed position to the open position the conveyor alignment mechanism moves the alignment member from the first position to the second position.
Clause 20. The reflow soldering oven of clause 19, wherein the conveyor alignment mechanism is configured to move the alignment member from the second position to the first position when the door is moved from the open position to the closed position.
Clause 21. The reflow soldering oven of clause 19 to clause 20, wherein the alignment member is configured to reciprocatingly move between the first position and the second position.
Clause 22. The reflow soldering oven of clause 19, clause 20 or clause 21, wherein the door
opening mechanism is configured to reciprocatingly move the door between the open position and the closed position in a door opening plane, which door opening plane is perpendicular to an alignment member plane in which the alignment member moves between the first position and the second position.
Clause 23. The reflow soldering oven of any one of clauses 19 to 22, wherein the conveyor alignment mechanism comprises a connector and the connector comprises a first end and an opposing second end, wherein the first end of the connector is operably coupled to the alignment member and the second end of the connector is operably coupled to the door opening
   mechanism such that movement of the door opening mechanism causes movement of the alignment member.
Clause 24. The reflow soldering oven of clause 23, wherein the first end of the connector moves with the alignment member in the alignment member plane and the second end of the connector moves with the door opening mechanism in the door opening plane.
Clause 25. The reflow soldering oven of any one of clauses 19 to 24, wherein the door opening mechanism comprises a channel, wherein the channel extends through at least a portion of the door opening mechanism and is configured to receive the alignment member, and
   wherein the alignment member is configured to reciprocatingly move between the first conveyor and the second conveyor through the channel.
Clause 26. The reflow soldering oven of any one of clauses 19 to 25, comprising an actuator, wherein the actuator is configured to move the door between the open position and the
   closed position and therefore move the conveyor alignment mechanism to hold the first conveyor and the second conveyor in the aligned configuration when the door is in the open position and release the first conveyor and the second conveyor from the aligned configuration
   when the door moves from the open position to the closed position.
Clause 27. The reflow soldering oven of any one of clauses 19 to 26,
   wherein the door is an entrance door and the vacuum chamber comprises an exit door;
   wherein the first conveyor is an entrance conveyor and is positioned outside of the vacuum chamber adjacent the entrance door; and
   the reflow soldering oven comprises a third exit conveyor that is positioned outside of the vacuum chamber adjacent the exit door;
   wherein the door opening mechanism is a first door opening mechanism and the reflow soldering oven comprises a second door opening mechanism,
   wherein the second door opening mechanism is configured to move the exit door between an open position, in which an item may be conveyed between the second conveyor and the third conveyor, and a closed position, in which the second conveyor and the third conveyor are separated by the exit door; and
   wherein the conveyor alignment mechanism is a first conveyor alignment mechanism and the reflow soldering oven comprises a second conveyor alignment mechanism that is operably connected to the second door opening mechanism and is configured to hold the second conveyor and the third conveyor in an aligned configuration when the exit door is in the open position.

**LIST OF FEATURES**

| | | | |
|---|---|---|---|
| 100 | printed circuit board | 318 | exit door |
| 102 | substrate | 320 | exit |
| 104 | electronic element | 400 | reflow soldering oven |
| 200 | reflow soldering oven | 402 | vacuum system |
| 202 | heating area | 404 | vacuum chamber |
| 204 | cooling area | 406 | first conveyor path |
| 206 | first conveyor | 410 | first conveyor |
| 208 | first conveyor path | 412 | second conveyor |
| 210 | second conveyor | 414 | third conveyor |
| 212 | second conveyor path | 416 | fourth conveyor |
| 300 | reflow soldering oven | 418 | fifth conveyor |
| 302 | vacuum chamber | 420 | sixth conveyor |
| 304 | heating area | 422 | entrance door |
| 306 | cooling area | 424 | exit door |
| 308 | first conveyor | 426 | first door opening mechanism |
| 310 | entrance | 428 | second door opening mechanism |
| 312 | entrance door | 430 | third door opening mechanism |
| 314 | second conveyor | 432 | fourth door opening mechanism |
| 316 | third conveyor | 434 | first conveyor alignment mechanism |
| 436 | second conveyor alignment mechanism | 526 | entrance door |
| 438 | third conveyor alignment mechanism | 528 | exit door |
| 440 | fourth conveyor alignment mechanism | 530 | seal |
| 500 | reflow soldering oven | 532 | conveyor alignment mechanism |
| 502 | vacuum system | 534 | longitudinal axis |
| 504 | vacuum chamber | 536 | door opening plane |
| 506 | upper chamber portion | 538 | body |
| 508 | lower chamber portion | 540 | shaft channel |
| 510 | entrance | 542 | alignment member |
| 512 | exit | 544 | first end |
| 514 | conveyor path | 546 | opposing second end |
| 516 | first conveyor | 548 | opening |
| 518 | second conveyor | 550 | longitudinal axis |
| 520 | first door opening mechanism | 552 | alignment member plane |
| 520a | shaft | 554 | alignment member channel |
| 520b | shaft | 556 | connector |
| 522 | second door opening mechanism | 558 | first end |
| 522a | shaft | 560 | opposing second end |
| 522b | shaft | | |
| 524 | base | | |

## Claims

1. A reflow soldering oven comprising:
a vacuum chamber;
a first conveyor that is positioned outside of the vacuum chamber; and
a second conveyor that is positioned inside the vacuum chamber;
wherein the first conveyor comprises a first conveyor side rail having a longitudinal axis, and the second conveyor comprises a second conveyor side rail having a longitudinal axis; and
wherein the reflow soldering oven comprises:
a conveyor alignment mechanism comprising an alignment member;
wherein the alignment member is movably coupled to one of the first conveyor side rail and the second conveyor side rail, and the conveyor alignment mechanism is configured to move the alignment member between:
a first position in which the alignment member is spaced apart from the other of the first conveyor side rail and the second conveyor, and
a second position in which the alignment member engages the other of the first conveyor side rail and the second conveyor side rail such that the first conveyor and the second conveyor are held in an aligned configuration in which the longitudinal axis of the first conveyor side rail is aligned with the longitudinal axis of the second conveyor side rail.

2. The reflow soldering oven of claim 1, wherein the other of the first conveyor and the second conveyor includes an opening within which the alignment member is at least partially received when the first conveyor and the second conveyor are in the aligned configuration.

3. The reflow soldering oven of claim 2, wherein the opening is provided in the side rail of the other of the first conveyor and the second conveyor.

4. The reflow soldering oven of claim 2 or claim 3, wherein the opening forms part of a blind hole in the other of the first conveyor and the second conveyor.

5. The reflow soldering oven of any one of claims 1 to 4, wherein the vacuum chamber comprises a door and the reflow soldering oven comprises a door opening mechanism that is configured to move the door between:
an open position, in which an item may be conveyed between the first conveyor and the second conveyor, and
a closed position, in which the first conveyor and the second conveyor are separated by the door; and
wherein the conveyor alignment mechanism is operably connected to the door opening mechanism such that when the door is moved from the closed position to the open position the conveyor alignment mechanism moves the alignment member from the first position to the second position.

6. The reflow soldering oven of claim 5, wherein the conveyor alignment mechanism is configured to move the alignment member from the second position to the first position when the door is moved from the open position to the closed position.

7. The reflow soldering oven of claim 5 or claim 6, wherein the alignment member is configured to reciprocatingly move between the first position and the second position.

8. The reflow soldering oven of claim 5, claim 6 or claim 7, wherein the door opening mechanism is configured to reciprocatingly move the door between the open position and the closed position in a door opening plane, which door opening plane is perpendicular to an alignment member plane in which the alignment member moves between the first position and the second position.

9. The reflow soldering oven of any one of claims 5 to 8, wherein the conveyor alignment mechanism comprises a connector and the connector comprises a first end and an opposing second end, wherein the first end of the connector is operably coupled to the alignment member and the second end of the connector is operably coupled to the door opening mechanism such that movement of the door opening mechanism causes movement of the alignment member.

10. The reflow soldering oven of claim 9, wherein the first end of the connector moves with the alignment member in the alignment member plane and the second end of the connector moves with the door opening mechanism in the door opening plane.

11. The reflow soldering oven of any one of claims 5 to 10, wherein the door opening mechanism comprises a channel, wherein the channel extends through at least a portion of the door opening mechanism and is configured to receive the alignment member, and wherein the alignment member is configured to reciprocatingly move between the first conveyor and the second conveyor through the channel.

12. The reflow soldering oven of any one of claims 5 to 11, comprising an actuator, wherein the actuator is configured to move the door between the open position and the closed position and therefore move the conveyor alignment mechanism to hold the first conveyor and the second conveyor in the aligned configuration when the door is in the open position and release the first conveyor and the second conveyor from the aligned configuration when the door moves from the open position to the closed position.

13. The reflow soldering oven of any one of claims 5 to 12,
wherein the door is an entrance door and the vacuum chamber comprises an exit door;
wherein the first conveyor is an entrance conveyor and is positioned outside of the vacuum chamber adjacent the entrance door; and
the reflow soldering oven comprises a third exit conveyor that is positioned outside of the vacuum chamber adjacent the exit door;
wherein the door opening mechanism is a first door opening mechanism and the reflow soldering oven comprises a second door opening mechanism,
wherein the second door opening mechanism is configured to move the exit door between an open position, in which an item may be conveyed between the second conveyor and the third conveyor, and a closed position, in which the second conveyor and the third conveyor are separated by the exit door; and
wherein the conveyor alignment mechanism is a first conveyor alignment mechanism and the reflow soldering oven comprises a second conveyor alignment mechanism that is operably connected to the second door opening mechanism and is configured to hold the second conveyor and the third conveyor in an aligned configuration when the exit door is in the open position.
